# EUROPEAN PATENT APPLICATION

(11) **EP 4 753 419 A1**
(43) Date of publication of application: **03.06.2026**
(21) Application number: 25202930.1
(22) Date of filing: 18.09.2025
(51) Int. Cl.: H10K 59/12, H10K 59/38, H10K 59/80, H10K 77/10

(54) **DISPLAY DEVICE AND METHOD OF MANUFACTURING DISPLAY DEVICE**

(30) Priority: 28.11.2024 KR 20240173294
(71) Applicant: LG Display Co., Ltd., Seoul, 07336 (KR)
(72) Inventor: CHOI, Hyeju, 10845 Paju-si, Gyeonggi-do (KR); SONG, Taejoon, 10845 Paju-si, Gyeonggi-do (KR)
(74) Representative: Bryn-Jacobsen, Caelia

(57) **Abstract**

A display device can include first, second and third light-emitting elements disposed on a first substrate, an optical gap layer disposed on the first, second and third light-emitting elements, a second substrate disposed on the optical gap layer, first, second and third color filters disposed on the second substrate, first, second and third concave portions on a lower surface of the second substrate, and first, second and third lenses on an upper surface of the optical gap layer, in which the first, second and third lenses fill the first, second and third concave portions, respectively.

## Description

### BACKGROUND

### Technical Field

The present disclosure relates to a display device and a method of manufacturing a display device, and more particularly, for example, without limitation, to a display device in which a thickness and a manufacturing cost can be reduced.

### Discussion of the Related Art

There are advantages in that organic light emitting diode display devices as the self-luminous types have a wider viewing angle and a higher contrast ratio than liquid crystal display devices, and are lighter and thinner and have low consumed power because they do not require a separate backlight. In addition, the organic light emitting diode display devices have the advantages of being capable of DC low voltage driving, having a fast response time, and especially having the inexpensive manufacturing cost.

Recently, head mounted display devices including the organic light emitting diode display device have been developed. The head mounted display device can implement virtual reality (VR) or augmented reality (AR).

However, existing methods for manufacturing thinner and more cost-effective displays, such as those that integrate optical components like lenses directly into the device structure, face significant challenges. The processes to form these integrated layers are often incompatible with the sensitive materials used in the display's light-emitting array. Also, existing methods often result in a high rate of defects, which lowers the overall production yield and increases manufacturing costs.

To reduce thicknesses and manufacturing costs of organic light-emitting diode display devices, attempts are being made to internalize structures for removing a viewing angle control film and a polarizing plate into the organic light-emitting diode display devices. Research and development for forming lenses on an encapsulation layer of an organic light-emitting diode display device to remove a viewing angle control film or forming color filters on an encapsulation layer of an organic light-emitting diode display device to remove a polarizing plate are being conducted.

However, since the organic light-emitting diode display device includes an organic light-emitting layer, process temperature is limited to less than 100 °C to form lenses or color filters on an encapsulation layer. For this reason, adhesion defects at interfaces between the lenses or color filters and adjacent layers or problems due to outgassing can occur.

In addition, when lenses are formed on an encapsulation layer using a high refractive index organic material, it can be difficult to reproducibly form lenses of a desired shape. Accordingly, there is a problem that a lower light-emitting array substrate on which organic light-emitting elements are formed is discarded due to defects during a process of forming a lens, which increases a manufacturing cost of an organic light-emitting diode display device.

Thus, a need exists for a display device in which a thickness can be reduced and a method for manufacturing the same which improves production yield, reduces manufacturing costs, and enhances device reliability by overcoming challengers regarding forming integrated optical structures on sensitive components, such as temperature sensitive light-emitting arrays.

The description provided in the discussion of the related art section should not be assumed to be prior art merely because it is mentioned in or associated with that section. The discussion of the related art section can include information that describes one or more aspects of the subject technology, and the description in this section does not limit the present disclosure.

### SUMMARY OF THE DISCLOSURE

The present disclosure has been made in view of the above problems and it is an object of the present disclosure to provide a device and method that can provide a display device in which a thickness and a manufacturing cost can be reduced.

Another object of the present disclosure is also to prevent a light-emitting array substrate from being discarded due to defects related to the formation of a lens and increase a production yield of a display device.

An object of the present disclosure is also to provide a method of manufacturing a display device in which a manufacturing process of lenses can be simplified and lenses of a desired shape can be reproducibly formed.

Another object of the present disclosure is also to improve reliability of a display device including an organic light-emitting layer.

An object of the present disclosure is also to provide a display device in which production energy required for production can be reduced and greenhouse gas emissions can be reduced.

Objects of the present disclosure are not limited to the above-described objects, and other objects that are not mentioned will be able to be clearly understood by those skilled in the art based on the following description.

According to examples of the present disclosure, there is provided a display device including first to third light-emitting elements disposed on a first substrate, an optical gap layer disposed on the first to third light-emitting elements, a second substrate disposed on the optical gap layer, and first to third color filters disposed on the second substrate, in which first to third concave portions are provided on a lower surface of the second substrate, and first to third lenses that fill the first to third concave portions, respectively, are provided on an upper surface of the optical gap layer.

According to examples of the present disclosure, there is provided a display device including a light-emitting array substrate including a first substrate, first to third light-emitting elements disposed on the first substrate, an optical gap layer disposed on the first to third light-emitting elements, first to third lenses formed on an upper surface of the optical gap layer, and a dam surrounding side surfaces of the optical gap layer, and an optical substrate including a second substrate, first to third color filters disposed on the second substrate, and first to third concave portions provided to overlap with the first to third color filters on a lower surface of the second substrate, in which the light-emitting array substrate and the optical substrate are bonded by the optical gap layer so that the first to third lenses fill the first to third concave portions, respectively.

According to examples of the present disclosure, there is provided a method of manufacturing a display device including forming a light-emitting array substrate including first to third light-emitting elements disposed on a first substrate, an optical gap layer disposed on the first to third light-emitting elements, and a dam surrounding side surfaces of the optical gap layer, forming an optical substrate including first to third color filters disposed on a second substrate, and first to third concave portions provided to overlap with the first to third color filters on a lower surface of the second substrate, and bonding the light-emitting array substrate and the optical substrate so that the first to third concave portions are filled by a part of the optical gap layer.

According to examples of the present disclosure, there is provided a display device including a plurality of sub-pixels, each including a light emitting element disposed on a first substrate; an optical gap layer disposed on the light emitting element; a second substrate disposed on the optical gap layer, a plurality of concave portions are provided on a lower surface of the second substrate, and a plurality of lenses that fill the plurality of concave portions, respectively, are provided on an upper surface of the optical gap layer.

According to the examples of the present disclosure, since the lenses and the color filters are internalized in the display device and the viewing angle control film and the polarizing plate can be eliminated, it is possible to reduce the thickness and the manufacturing cost of the display device.

According to the examples of the present disclosure, since the light-emitting array substrate on which the light-emitting elements are formed and the optical substrate on which the color filters and the lens-shaped concave portions are formed are manufactured separately and then the light-emitting array substrate and the optical substrate are bonded to ultimately form the display device, it is possible to prevent the light-emitting array substrate from being discarded due to defects related to the formation of the lenses and increase the production yield of the display device.

According to the examples of the present disclosure, since the lens-shaped concave portions are formed on the second substrate formed of low-refractive index glass by the wet etching process and high-refractive index organic materials disposed on the first substrate fill the concave portions of the second substrate to form the lenses, the manufacturing process of the lenses can be simplified, and lenses of a desired shape can be reproducibly formed.

According to the examples of the present disclosure, by arranging the second substrate formed of glass on the light-emitting elements and using the second substrate as the encapsulation structure, it is possible to improve the reliability of the display device including the organic light-emitting layer.

According to the examples of the present disclosure, since the production yield of the display device is improved and the reliability is improved, the production energy of the display device can be reduced and greenhouse gas emissions can be reduced.

Effects of the present disclosure are not limited to the above-described effects, and other effects that are not mentioned will be able to be clearly understood by those skilled in the art based on the above detailed description.

It is to be understood that both the foregoing general description and the following detailed description of the present disclosure are example and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate examples of the disclosure and together with the description serve to explain the principle of the disclosure. In the drawings:
FIG. 1 is a plan view of a display device according to an example of the present disclosure.
FIG. 2 is a schematic plan view showing one pixel of the display device according to an example of the present disclosure.
FIG. 3 is a cross-sectional view of the display device along line III-III in FIG. 2 according to an example of the present disclosure.
FIG. 4 is a cross-sectional view of the display device along line IV-IV in FIG. 1 according to an example of the present disclosure.
FIG. 5 is a schematic cross-sectional view showing one pixel of the display device according to an example of the present disclosure and shows an area corresponding to FIG. 3.
FIG. 6 is a schematic cross-sectional view showing one pixel of the display device according to an example of the present disclosure and shows an area corresponding to FIG. 4.
FIG. 7 is a schematic cross-sectional view showing one pixel of the display device according to an example of the present disclosure and shows an area corresponding to FIG. 3.
FIG. 8 is a schematic cross-sectional view showing one pixel of the display device according to an example of the present disclosure and shows an area corresponding to FIG. 4.
FIG. 9 is a schematic plan view showing one pixel of the display device according to an example of the present disclosure.
FIG. 10 is a cross-sectional view of the display device along line X-X in FIG. 9 according to an example of the present disclosure.
FIGS. 11 to 13 show a process of manufacturing a display device according to the example shown in FIG. 3.
FIGS. 14 to 16 show a process of manufacturing a display device according to the example shown in FIG. 5.
FIGS. 17 and 18 show a process of manufacturing a display device according to the example shown in FIG. 7.
FIGS. 19 to 21 show a process of manufacturing a display device according to the example shown in FIG. 10.

Throughout the drawings and the detailed description, unless otherwise described, the same drawing reference numerals should be understood to refer to the same elements, features, and structures. The sizes, lengths, and thicknesses of layers, regions and elements, and depiction thereof can be exaggerated for clarity, illustration, and convenience.

### DETAILED DESCRIPTION OF THE EMBODIMENTS

Reference will now be made in detail to examples of the present disclosure, examples of which can be illustrated in the accompanying drawings. The progression of processing steps and/or operations described is an example; however, the sequence of steps and/or operations is not limited to that set forth herein and can be changed as is known in the art, with the exception of steps and/or operations necessarily occurring in a particular order. Names of the respective elements used in the following explanations can be selected only for convenience of writing the specification and can be thus different from those used in actual products.

Advantages and features of the present disclosure and methods for achieving them will become clear by referencing examples described below in detail in conjunction with the accompanying drawings. However, the present disclosure is not limited to the examples disclosed below but will be implemented in various different forms, these examples are merely provided to make the disclosure of the present disclosure complete and fully inform those skilled in the art to which the present disclosure pertains of the scope of the present disclosure.

Since shapes (e.g., sizes, lengths, widths, heights, thicknesses, locations, radii, diameters, and areas), ratios, angles, numbers, etc. disclosed in the drawings for describing the examples of the present disclosure are illustrative, the present disclosure is not limited to the shown items. The same reference number denotes the same components throughout the specification. In addition, in describing the present disclosure, when it is determined that the detailed description of a related known technology can unnecessarily obscure the gist of the present disclosure, the detailed description thereof will be omitted or briefly given. When "comprise," "have," "consist of," "make up of," "formed of," or the like described herein are used, other parts can be added unless "only" is used. When a component is expressed in a singular form, it includes a situation in which the component is provided as a plurality of components unless specifically stated otherwise.

The word "example" is used to mean serving as an example or illustration. Aspects are example aspects. "Embodiments," "examples," "aspects," and the like should not be construed as preferred or advantageous over other implementations. An example, an example, an examples, an aspect, or the like can refer to one or more examples, one or more examples, one or more examples, one or more aspects, or the like, unless stated otherwise. Further, the term "can" encompasses all the meanings of the term "can."

In construing a component, the component is construed as including a margin of error even when there is no separate explicit description related to the margin of error.

When the positional relationship is described, for example, when the positional relationship between two parts is described using "on," "above," "under," "next to," or the like, one or more other parts can be positioned between the two parts, for example, unless "immediately," "directly," or "close to" is used. For example, where an element or layer is disposed "on" another element or layer, a third layer or element can be interposed therebetween.

When the temporal relationship is described, when the temporal relationship is described using "after," "subsequently," "then," "before," or the like, it can also include a nonconsecutive situation unless "immediately" or "directly" is used.

Although terms such as first and second are used to describe various components, these components are not limited by these terms. These terms are only used to distinguish one component from another component. Therefore, a first component described below can be a second component.

In the description of components of the present disclosure, terms such as first, second, A, B, (a), and (b) can be used. These terms are only for the purpose of distinguishing one component from another component, and the nature, sequence, order, or the like of the corresponding component is not limited by these terms. For example, a first element could be termed a second element, and, similarly, a second element could be termed a first element, without departing from the scope of the present disclosure.

When a certain component is described as being "connected," "coupled," "joined," or "attached" to another component, the certain component can be connected, coupled, joined, or attached directly to another component, but it should be understood that still another component can be interposed between components that can be connected, coupled, joined, or attached indirectly unless otherwise stated specially.

When a component or a layer is described as "coming into contact with" or "overlapping" another component or layer, the component or the layer can come into direct contact with or directly overlap another component or layer, but it should be understood that still another component can be interposed between components that can come into indirect contact with and indirectly overlap each other unless otherwise stated specially.

It should be understood that "at least one" includes any combination of one or more of associated components. For example, "at least one of first, second, and third components" can include not only the first, second, or third component, but also any combination of two or more of the first, second, and third components.

The terms "first direction," "second direction," "third direction," "X-axis direction," "Y-axis direction," and "Z-axis direction" should not be construed as merely the geometric relationship in which the relationship therebetween is perpendicular and can refer to a wider directionality within the range in which the configuration of the present disclosure can act functionally.

Unless otherwise defined, all terms (including technical and scientific terms) used herein have the same meaning as commonly understood by one of ordinary skill in the art to which examples belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" can apply, for example, to a separate circuit or structure, an integrated circuit, a computational block of a circuit device, or any structure configured to perform a described function as should be understood to one of ordinary skill in the art.

Features of various examples of the present disclosure can be coupled or combined partially or entirely, various technological interworking and driving are made possible, and the examples can be implemented independently of each other or implemented together in an associated relationship.

Hereinafter, various examples of the present disclosure will be described in detail with reference to the accompanying drawings.

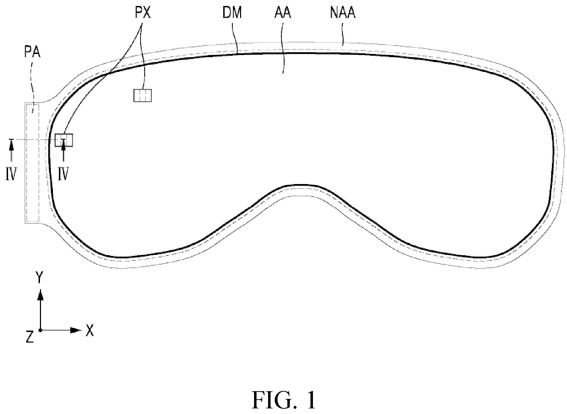

FIG. 1 is a plan view of a display device according to one example of the present disclosure.

Referring to FIG. 1, a display device according to one example of the present disclosure includes an active area AA and a non-active area NAA. The active area AA and the non-active area NAA can be areas of a substrate. The active area AA is an area in which an image is implemented. The non-active area NAA is an area in which an image is not implemented and which is positioned outside the active area AA. The non-active area NAA can be also referred to as an edge area or a bezel area. An appearance of the display device can be formed by a laser trimming process. The display device according to one example of the present disclosure is illustrated as having a goggle shape, but the shape of the display device is not limited thereto. One display device that displays a left-eye image and a right-eye image can be mounted on a head mounted display (HMD) for implementing virtual reality (VR) or augmented reality (AR), but the left-eye display device and the right-eye display device can be mounted separately. The display device according to one example of the present disclosure can be used as a left-eye display device and a right-eye display device and can have the shape suitable therefor.

The active area AA is an area in which a plurality of pixels PX are arranged. Each pixel PX can include a plurality of sub-pixels. The non-active area NAA is an area in which a gate driver, various link lines, various power supply lines, etc. are disposed.

The active area AA includes a plurality of data lines and a plurality of gate lines that are disposed to intersect each other. Each of the plurality of data lines can be configured to extend in a first direction. Each of the plurality of gate lines can be configured to extend in a second direction different from the first direction.

A closed curve-shaped dam DM can be disposed along an edge of the active area AA. One dam DM is shown in FIG. 1, but the examples of the present disclosure are not limited thereto. Two or more closed curve-shaped dams DM can be disposed along the edge of the active area AA.

The non-active area NAA can be disposed to surround the active area AA. The non-active area NAA can include a pad area PA to which a flexible printed circuit board having a data driver mounted is bonded. A position of the pad area PA is not limited to that shown in FIG. 1.

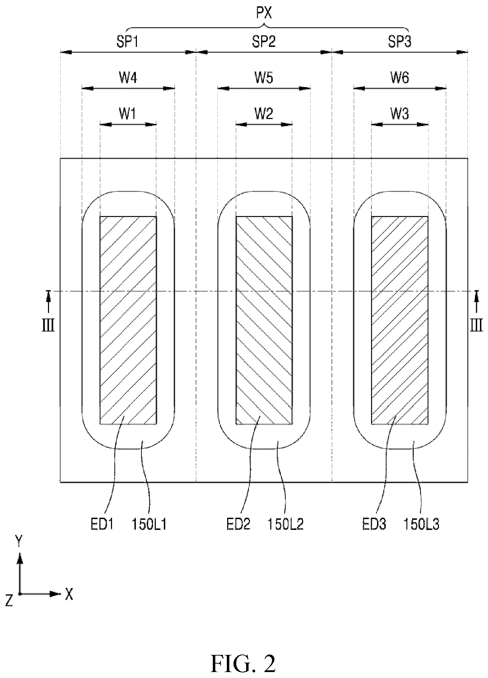

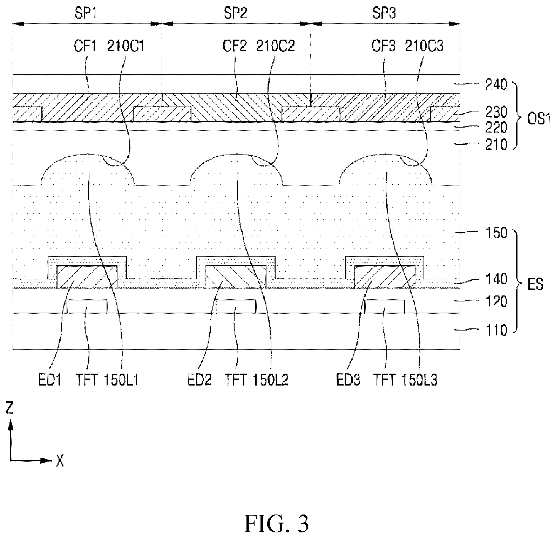

FIG. 2 is a schematic plan view showing one pixel of the display device according to one example of the present disclosure. FIG. 3 is a cross-sectional view of the display device along line III-III in FIG. 2.

Referring to FIG. 2, a pixel PX of the display device according to the example of the present disclosure can include a plurality of sub-pixels such as a first sub-pixel SP1, a second sub-pixel SP2, and a third sub-pixel SP3, but is not limited thereto. More or less sub-pixels can be possible. The first sub-pixel SP1 can be, for example, a red sub-pixel, the second sub-pixel SP2 can be, for example, a green sub-pixel, and the third sub-pixel SP3 can be, for example, a blue sub-pixel, but is not limited thereto. In another example, each of the first sub-pixel SP1, the second sub-pixel SP2, and the third sub-pixel SP3 can display one color among cyan, magenta and yellow.

The first sub-pixel SP1 can include a first light-emitting element ED1, and a first lens 150L1 overlapping with the first light-emitting element ED1. In a plan view, the first lens 150L1 can have a larger area than the first light-emitting element ED1. A width W4 of the first lens 150L1 can be larger than a width W1 of the first light-emitting element ED1 (e.g., W4 > W1). The first light-emitting element ED1 can emit, for example, red light. The width W1 of the first light-emitting element ED1 and the width W4 of the first lens 150L1 are widths measured in an X-axis direction.

The second sub-pixel SP2 can include a second light-emitting element ED2, and a second lens 150L2 overlapping with the second light-emitting element ED2. In a plan view, the second lens 150L2 can have a larger area than the second light-emitting element ED2. A width W5 of the second lens 150L2 can be larger than a width W2 of the second light-emitting element ED2 (e.g., W5 > W2). The second light-emitting element ED2 can emit, for example, green light. The width W2 of the second light-emitting element ED2 and the width W5 of the second lens 150L2 are widths measured in the X-axis direction.

The third sub-pixel SP3 can include a third light-emitting element ED3, and a third lens 150L3 overlapping with the third light-emitting element ED3. In a plan view, the third lens 150L3 can have a larger area than the third light-emitting element ED3. A width W6 of the third lens 150L3 can be larger than a width W3 of the third light-emitting element ED3 (e.g., W6 > W3). The third light-emitting element ED3 can emit, for example, blue light. The width W3 of the third light-emitting element ED3 and the width W6 of the third lens 150L3 are widths measured in the X-axis direction.

In the present example, the width W1 of the first light-emitting element ED1, the width W2 of the second light-emitting element ED2, and the width W3 of the third light-emitting element ED3 can be the same as each other. The width W4 of the first lens 150L1, the width W5 of the second lens 150L2, and the width W6 of the third lens 150L3 can be the same. However, the examples are not limited thereto. In another example, the width W1 of the first light-emitting element ED1, the width W2 of the second light-emitting element ED2, and the width W3 of the third light-emitting element ED3 can be different, and the width W4 of the first lens 150L1, the width W5 of the second lens 150L2, and the width W6 of the third lens 150L3 can be different.

Referring to FIG. 3, the display device according to one example of the present disclosure can include a light-emitting array substrate ES and an optical substrate OS1. The light-emitting array substrate ES and the optical substrate OS1 can be manufactured separately and then bonded together.

The light-emitting array substrate ES can include a first substrate 110, a plurality of thin film transistors TFT disposed on the first substrate 110, an insulating layer 120 covering the plurality of thin film transistors TFT, first, second and third light-emitting elements ED1, ED2, and ED3 disposed on the insulating layer 120, a passivation layer 140 covering the first, second and third light-emitting elements ED1, ED2, and ED3 and disposed on the insulating layer 120, an optical gap layer 150 disposed on the passivation layer 140, and first, second and third lenses 150L1, 150L2, and 150L3 formed on an upper portion of the optical gap layer 150.

The first substrate 110 can include a flexible organic insulation material, but is not limited thereto. For example, the first substrate 110 can be made of an organic insulation material such as polyimide (PI). For example, the first substrate 110 can have a multilayered structure in which organic insulation material layers and inorganic insulation material layers are alternately stacked.

For example, the first substrate 110 can include glass, plastic, or a flexible polymer film. For example, the flexible polymer film can be made of any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC) film, polyvinyl alcohol(PVA) film, polyimide(PI) film, and polystyrene(PS), which is only an example and is not necessarily limited thereto.

Each of the first sub-pixel SP1, the second sub-pixel SP2, and the third sub-pixel SP3 can include at least one thin film transistor TFT disposed on the first substrate 110. For example, the thin film transistor TFT can be disposed on a portion of the first substrate 110.

The insulating layer 120 can include a plurality of insulation material layers. Some of the plurality of insulation material layers included in the insulating layer 120 can insulate components of the thin film transistor TFT. The plurality of insulation material layers can include an inorganic insulation material layer and an organic insulation material layer. The insulating layer 120 can be configured to cover the thin film transistor TFT and the portion of the first substrate 110 exposed by the thin film transistor TFT.

The first sub-pixel SP1 can include the first light-emitting element ED1, the second sub-pixel SP2 can include the second light-emitting element ED2, and the third sub-pixel SP3 can include the third light-emitting element ED3.

At least one thin film transistor TFT in the first sub-pixel SP1 can be electrically connected to the first light-emitting element ED1. At least one thin film transistor TFT in the second sub-pixel SP2 can be electrically connected to the second light-emitting element ED2. At least one thin film transistor TFT in the third sub-pixel SP3 can be electrically connected to the third light-emitting element ED3.

The passivation layer 140 can protect the first, second and third light-emitting elements ED1, ED2, and ED3. The passivation layer 140 can be formed of an inorganic insulation material. The passivation layer 140 can have a multilayered structure in which an inorganic insulation material and an organic insulation material are stacked on each other, but is not limited thereto.

The optical gap layer 150 can be disposed on the passivation layer 140. In this situation, the optical gap layer 150 can be formed to a predetermined thickness in consideration of sizes of the light-emitting elements and the like in order to limit a viewing angle to, for example, 30°. A thickness of the optical gap layer 150 can, for example, range from about 25 µm to 35 µm (e.g., 30 µm).

The first sub-pixel SP1 can include the first lens 150L1, the second sub-pixel SP2 can include the second lens 150L2, and the third sub-pixel SP3 can include the third lens150L3.

The first, second and third lenses 150L1, 150L2, and 150L3 can be formed integrally with the optical gap layer 150. For example, the three lenses 150L1, 150L2, and 150L3 and the optical gap layer 150 can be formed as a single, continuous piece. The first, second and third lenses 150L1, 150L2, and 150L3 can be convexly protruded from an upper surface of the optical gap layer 150. Since the first lens 150L1 formed on the upper surface of the optical gap layer 150 can be disposed to overlap with the first light-emitting element ED1, light emitted from the first light-emitting element ED1 can be condensed or focused by the first lens 150L1. Since the second lens 150L2 formed on the upper surface of the optical gap layer 150 can be disposed to overlap with the second light-emitting element ED2, light emitted from the second light-emitting element ED2 can be condensed or focused by the second lens 150L2. Since the third lens 150L3 formed on the upper surface of the optical gap layer 150 can be disposed to overlap with the third light-emitting element ED3, light emitted from the third light-emitting element ED3 can be condensed or focused by the third lens 150L3. By providing the first, second and third lenses 150L1, 150L2, and 150L3 formed on the upper surface of the optical gap layer 150, the light emitted from the first, second and third light-emitting elements ED1, ED2, and ED3 is condensed, thereby increasing frontal luminance and limiting or narrowing the left and right viewing angles to, for example, within 30°.

For example, the first lens 150L1 can be disposed to overlap with the first light-emitting element ED1 in the first sub-pixel SP1, the second lens 150L2 can be disposed to overlap the second light-emitting element ED2 in the second sub-pixel SP2, and the third lens 150L3 can be disposed to overlap with the third light-emitting element ED3 in the third sub-pixel SP3.

The first, second and third lenses 150L1, 150L2, and 150L3 and the optical gap layer 150 can be formed of an organic insulation material. A refractive index of the organic insulation material forming the first, second and third lenses 150L1, 150L2, and 150L3 and the optical gap layer 150 can be higher than a refractive index of glass forming a second substrate 210 to be described below. The refractive index of the organic insulation material forming the first, second and third lenses 150L1, 150L2, and 150L3 and the optical gap layer 150 can range from 1.6 to 1.9 (e.g., 1.75). To increase the light condensing efficiency by the first, second and third lenses 150L1, 150L2, and 150L3 and prevent color mixing between pixels or sub-pixels, a difference between the refractive index of the glass forming the second substrate 210 and the refractive index of the organic insulation material forming the first, second and third lenses 150L1, 150L2, and 150L3 is preferably, for example, 0.18 or more. The first, second and third lenses 150L1, 150L2, and 150L3 and the optical gap layer 150 can be formed of, for example, an epoxy-based or acryl-based polymer material, but examples are not limited thereto.

The optical substrate OS1 can include the second substrate 210 disposed on the first, second and third lenses 150L1, 150L2, and 150L3, a color buffer layer 220 disposed on the second substrate 210, a black matrix 230 disposed on the color buffer layer 220, first, second and third color filters CF1, CF2, and CF3 disposed in openings of the black matrix 230, and a protective layer 240 covering the first, second and third color filters CF1, CF2, and CF3.

A lower surface of the second substrate 210 can be provided with first, second and third concave portions 210C1, 210C2, and 210C3. In other words, the lower surface of the second substrate 210 can fit on the upper surface of the optical gap layer 150 like two pieces of a puzzle. For example, the lower surface of the second substrate 210 can be provided with first concave portion 210C1 in the first sub-pixel SP1, the second concave portion 210C2 in the second sub-pixel SP2, and the third concave portion 210C3 in the third sub-pixel SP3. The first concave portion 210C1 can be positioned to overlap with the first color filter CF1 in the first sub-pixel SP1, the second concave portion 210C2 can be positioned to overlap with the second color filter CF2 in the second sub-pixel SP2, and the third concave portion 210C3 can be positioned to overlap with the third color filter CF3 in the third sub-pixel SP3.

The shape of the first concave portion 210C1 of the second substrate 210 can correspond to the shape of the first lens 150L1. The shape of the second concave portion 210C2 of the second substrate 210 can correspond to the shape of the second lens 150L2. The shape of the third concave portion 210C3 of the second substrate 210 can correspond to the shape of the third lens 150L3. The first, second and third lenses 150L1, 150L2, and 150L3 can be accommodated in the first, second and third concave portions 210C1, 210C2, and 210C3 of the second substrate 210, respectively. The first, second and third concave portions 210C1, 210C2, and 210C3 of the second substrate 210 can serve as a "mold" for forming the first, second and third lenses 150L1, 150L2, and 150L3. The lower surface of the second substrate 210 can come into contact with the upper surface of the optical gap layer 150. The first, second and third concave portions 210C1, 210C2, and 210C3 of the second substrate 210 can come into contact with the first, second and third lenses 150L1, 150L2, and 150L3. The first, second and third concave portions 210C1, 210C2, and 210C3 of the second substrate 210 can be filled with the first, second and third lenses 150L1, 150L2, and 150L3. In other words, the concave portions of the second substrate (210) can serve as a mold to form the lenses (150L1, 150L2, 150L3) by being filled with the material of the optical gap layer (150).

For example, the first concave portion 210C1 of the second substrate 210 can be filled with the first lens 150L1 in the first sub-pixel SP1, the second concave portion 210C2 of the second substrate 210 can be filled with the second lens 150L2 in the second sub-pixel SP2, and the third concave portion 210C3 of the second substrate 210 can be filled with the third lens 150L3 in the third sub-pixel SP3.

The second substrate 210 can be formed of low refractive index glass. A refractive index of the glass forming the second substrate 210 can be lower than the refractive index of the organic insulating material forming the first, second and third lenses 150L1, 150L2, and 150L3 and the optical gap layer 150. The refractive index of the glass forming the second substrate 210 can range from 1.4 to 1.5 (e.g., 1.45).

The color buffer layer 220 disposed on the second substrate 210 can be formed of an inorganic insulation material. In one example, the color buffer layer 220 can be omitted.

The black matrix 230 can be disposed on an upper surface of the color buffer layer 220, but, when the color buffer layer 220 is omitted according to an example, the black matrix 230 can be disposed on an upper surface of the second substrate 210. The black matrix 230 can include openings overlapping with the first, second and third concave portions 210C1, 210C2, and 210C3. For example, the black matrix 230 may not overlap with the first, second and third concave portions 210C1, 210C2, and 210C3. For example, the black matrix 230 can be disposed between the adjacent sub-pixels.

The first, second and third color filters CF1, CF2, and CF3 can be disposed in the openings of the black matrix 230. The first color filter CF1 can be positioned to overlap with the first concave portion 210C1 in the first sub-pixel SP1, the second color filter CF2 can be positioned to overlap with the second concave portion 210C2 in the second sub-pixel SP2, and the third color filter CF3 can be positioned to overlap with the third concave portion 210C3 in the third sub-pixel SP3. For example, the first color filter CF1 can be a red color filter, the second color filter CF2 can be a green color filter, and the third color filter CF3 can be a blue color filter, but is not limited thereto.

In the first sub-pixel SP1, the first light-emitting element ED1, the first lens 150L1, and the first color filter CF1 can be disposed to overlap with each other. In the second sub-pixel SP2, the second light-emitting element ED2, the second lens 150L2, and the second color filter CF2 can be disposed to overlap with each other. In the third sub-pixel SP3, the third light-emitting element ED3, the third lens 150L3, and the third color filter CF3 can be disposed to overlap with each other. By including the first, second and third color filters CF1, CF2, and CF3 and the black matrix 230 on the second substrate 210, reflection of external light by the components of the display device can be reduced without a polarizing plate.

The protective layer 240 covering the first, second and third color filters CF1, CF2, and CF3 can be formed of an organic insulation material.

The display device according to one example of the present disclosure can further include a lenticular film for implementing a three-dimensional image. The lenticular film can be disposed on the protective layer 240.

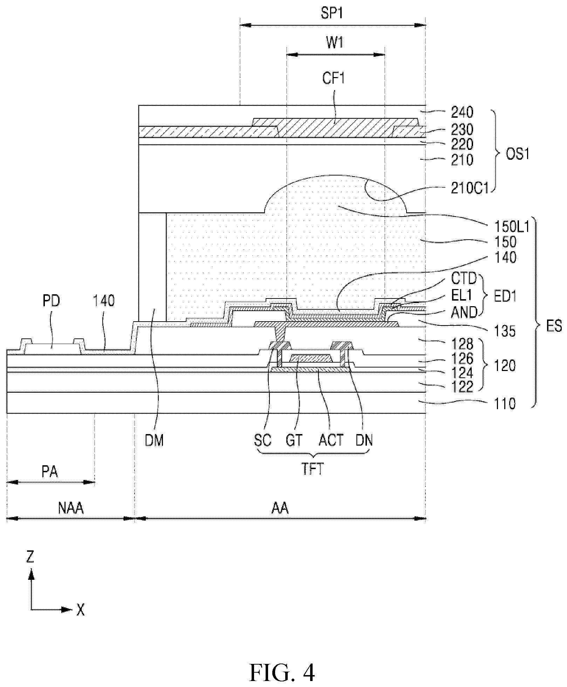

FIG. 4 is a cross-sectional view of the display device along line IV-IV in FIG. 1. FIG. 4 shows the first sub-pixel SP1 of the active area AA, the dam DM, and the pad area PA of the non-active area NAA.

Referring to FIG. 4, the display device can include the light-emitting array substrate ES and the optical substrate OS1. The light-emitting array substrate ES and the optical substrate OS1 can be bonded. For example, FIG. 4 shows an outer edge portion of the optical substrate OS1 and the pad area PA.

The light-emitting array substrate ES can include the first substrate 110, the insulating layer 120, the thin film transistor TFT, the first light-emitting element ED1, the dam DM, the optical gap layer 150, and the first lens 150L1. The optical substrate OS1 can have the same or similar configuration as that described with reference to FIG. 3.

The buffer layer 122 can be disposed on the first substrate 110. The buffer layer 122 can be a single layer or multiple layers formed of an inorganic insulation material such as silicon oxide, silicon nitride, and silicon oxynitride. The buffer layer 122 can be disposed not only in the active area AA, but also in the non-active area NAA.

The thin film transistor TFT can be disposed on the buffer layer 122 in the first sub-pixel SP1 of the active area AA. The thin film transistor TFT can include an active pattern ACT, a gate electrode GT, a source electrode SC, and a drain electrode DN. The active pattern ACT can include a semiconductor material. For example, the active pattern ACT can include a polycrystalline semiconductor material or an oxide semiconductor material.

A gate insulating layer 124 can be disposed on the active pattern ACT. For example, the gate insulating layer 124 can cover the active pattern ACT and extend along an upper surface of the buffer layer 122. For example, the gate insulating layer 124 can cover the active pattern ACT and a portion of the upper surface of the buffer layer 122 exposed by the active pattern ACT. The gate insulating layer 124 can be disposed not only in the active area AA, but also in the non-active area NAA. For example, the gate insulating layer 124 can include an inorganic insulation material such as silicon oxide, silicon nitride, and silicon oxynitride. The gate insulating layer 124 can include a material having a high dielectric constant. For example, the gate insulating layer 124 can include a high-k oxide such as hafnium oxide.

The gate electrode GT can be formed on the gate insulating layer 124. The gate electrode GT can include a conductive material. For example, the gate electrode GT can include a metal material such as aluminum (Al), chromium (Cr), copper (Cu), titanium (Ti), molybdenum (Mo), and tungsten (W).

The interlayer insulating layer 126 can be disposed on the gate electrode GT. For example, the interlayer insulating layer 126 can cover the gate electrode GT and extend along an upper surface of the gate insulating layer 124. For example, the interlayer insulating layer 126 can cover the gate electrode GT and a portion of the upper surface of the gate insulating layer 124 exposed by the gate electrode GT. The interlayer insulating layer 126 can be disposed not only in the active area AA, but also in the non-active area NAA. For example, the interlayer insulating layer 126 can include an inorganic insulation material such as silicon oxide, silicon nitride, and silicon oxynitride, but is not limited thereto. Also, according to an example, the buffer layer 122, the gate insulating layer 124, the interlayer insulating layer 126 can extend past an outer edge of the optical substrate OS1. Also, an edge of a planarization layer 128 can correspond to the outer edge of the optical substrate OS1, but examples are not limited thereto.

The source electrode SC and the drain electrode DN can be disposed on the interlayer insulating layer 126. For example, the source electrode SC and the drain electrode DN can include a metal material such as aluminum (Al), chromium (Cr), copper (Cu), titanium (Ti), molybdenum (Mo), and tungsten (W). For example, the source electrode SC and the drain electrode DN can have a multilayered structure of titanium (Ti)/aluminum (Al)/titanium (Ti).

The source electrode SC and the drain electrode DN can be electrically insulated from the gate electrode GT by the interlayer insulating layer 126. For example, the source electrode SC and the drain electrode DN can come into contact with the active pattern ACT through contact holes passing through the gate insulating layer 124 and the interlayer insulating layer 126.

A pad PD can be disposed on the interlayer insulating layer 126 in the pad area PA of the non-active area NAA. The pad PD can be formed of the same material as the source electrode SC and the drain electrode DN. Also, edges of the pad PD can be overlapped by portions of a passivation layer 140, which can help secure the pad PD in place.

A planarization layer 128 covering the source electrode SC and the drain electrode DN can be disposed on the interlayer insulating layer 126. For example, the planarization layer 128 can be configured to cover the source electrode SC and the drain electrode DN and a portion of the interlayer insulating layer 126. The planarization layer 128 can include an organic insulation material. For example, the planarization layer 128 can be formed of an acryl-based or polyimide-based organic material.

The buffer layer 122, the gate insulating layer 124, the interlayer insulating layer 126, and the planarization layer 128 can collectively form the insulating layer 120.

The first light-emitting element ED1 can be disposed on the planarization layer 128 in the first sub-pixel SP1. The first light-emitting element ED1 can include an anode electrode AND, a first light-emitting layer EL1, and a cathode electrode CTD. The first light-emitting layer EL1 can include, for example, an organic light-emitting material layer that emits light of a first color. The first light-emitting layer EL1 can include, for example, an organic light-emitting material layer that emits red light. The anode electrode AND can be electrically connected to the source electrode SC or the drain electrode DN of the thin film transistor TFT.

For example, the first light-emitting layer EL1 can include one or more of a hole injection layer (HIL), a hole transmitting layer (HTL), an electron transmitting layer (ETL) and an electron injection layer (EIL), but the present disclosure is not limited thereto.

The anode electrode AND can include a conductive material. For example, the anode electrode AND can have high reflectivity. For example, the anode electrode AND can include a metal material such as aluminum Al and silver Ag. The anode electrode AND can have a multilayered structure. For example, the anode electrode AND can have a structure in which a metal material such as aluminum (Al) or silver (Ag) is disposed between transparent conductive materials such as ITO and IZO.

A bank layer 135 can be disposed on the planarization layer 128. The bank layer 135 can include an organic insulation material. For example, the bank layer 135 can be formed of an acryl-based or polyimide-based organic material. The bank layer 135 can cover an edge of the anode electrode AND. The bank layer 135 can have an opening that exposes a part of the anode electrode AND.

The first light-emitting layer EL1 of the first light-emitting element ED1 can be disposed on the anode electrode AND exposed by a first opening of the bank layer 135 provided in the first sub-pixel SP1. The width W1 of the first light-emitting element ED1 can be defined as a width of the first opening of the bank layer 135 provided in the first sub-pixel SP1. The width W1 of the first light-emitting element ED1 can be defined as a width of a first light-emitting area, which is an area in which the first light-emitting layer EL1 comes into contact with the anode electrode AND. The first light-emitting layer EL1 can extend above a part of an upper surface of the bank layer 135.

The cathode electrode CTD can be disposed on the first light-emitting layer EL1 and can extend onto the upper surface of the bank layer 135. The cathode electrode CTD can cover the upper surface and side surfaces of the bank layer 135.

Also, the second light-emitting element ED2 can be disposed on the planarization layer 128 in the second sub-pixel SP2, and the third light-emitting element ED3 can be disposed on the planarization layer 128 in the third sub-pixel SP3. The second light-emitting element ED2 can include the anode electrode AND, the second light-emitting layer EL2, and the cathode electrode CTD. The second light-emitting layer EL2 can include, for example, an organic light-emitting material layer that emits light of a second color. The second light-emitting layer EL2 can include, for example, an organic light-emitting material layer that emits green light. The third light-emitting element ED3 can include the anode electrode AND, the third light-emitting layer EL3, and the cathode electrode CTD. The third light-emitting layer EL3 can include, for example, an organic light-emitting material layer that emits light of a third color. The third light-emitting layer EL3 can include, for example, an organic light-emitting material layer that emits blue light.

The second light-emitting layer EL2 of the second light-emitting element ED2 can be disposed on the anode electrode AND exposed by a second opening of the bank layer 135 provided in the second sub-pixel SP2. The width W2 of the second light-emitting element ED2 can be defined as a width of the second opening of the bank layer 135 provided in the second sub-pixel SP2. The width W2 of the second light-emitting element ED2 can be defined as a width of a second light-emitting area, which is an area in which the second light-emitting layer EL2 comes into contact with the anode electrode AND. The second light-emitting layer EL2 can extend above a part of the upper surface of the bank layer 135.

The third light-emitting layer EL3 of the third light-emitting element ED3 can be disposed on the anode electrode AND exposed by a third opening of the bank layer 135 provided in the third sub-pixel SP3. The width W3 of the third light-emitting element ED3 can be defined as a width of the third opening of the bank layer 135 provided in the third sub-pixel SP3. The width W3 of the third light-emitting element ED3 can be defined as a width of a third light-emitting area, which is an area in which the third light-emitting layer EL3 comes into contact with the anode electrode AND. The third light-emitting layer EL3 can extend above a part of the upper surface of the bank layer 135.

The cathode electrode CTD can be disposed on the second light-emitting layer EL2 and the third light-emitting layer EL3 and can extend above the upper surface of the bank layer 135. The cathode electrode CTD can be commonly disposed integrally on the first light-emitting layer EL1, the second light-emitting layer EL2, and the third light-emitting layer EL3.

The passivation layer 140 can be disposed on the cathode electrode CTD. The passivation layer 140 can extend above the planarization layer 128. The passivation layer 140 can extend to the non-active area NAA and expose the pad PD.

For example, the passivation layer 140, which can be a kind of inorganic or organic dielectric, can be made of any one of photo acrylic, polyimide, benzocyclobutene resin, and acrylate, etc. Also, the first, second and third light-emitting elements can be sealed between the planarization layer 128 and the passivation layer 140.

The dam DM and the optical gap layer 150 can be disposed on the passivation layer 140. The dam DM can be disposed in a closed curve shape (e.g., a closed loop shape) along the edge of the active area AA. For example, two or more closed curve-shaped dams DM can be disposed along the edge of the active area AA. The optical gap layer 150 can fill a space defined by the dam DM. The dam DM can allow the optical gap layer 150 to have a predetermined thickness throughout the active area AA. The dam DM can serve to block moisture and/or oxygen penetrating the side surfaces of the display device 100. The dam DM can be formed of, for example, an epoxy-based organic material. The dam DM can be formed of, for example, an epoxy-based organic material and an olefin-based organic material. The dam DM can further include a getter that absorbs moisture and a filler that extends a moisture penetration path.

For example, each of the first, second and third lenses 150L1, 150L2, and 150L3 formed on an upper portion of the optical gap layer 150 can be disposed in the first, second and third sub-pixels SP1, SP2 and SP3.

The first lens 150L1 can be provided on the upper portion of the optical gap layer 150 in the first sub-pixel SP1. Also, the second lens 150L2 can be disposed on the upper portion of the optical gap layer 150 in the second sub-pixel SP2, and the third lens 150L3 can be disposed on the upper portion of the optical gap layer 150 in the third sub-pixel SP3.

The optical substrate OS1 can be disposed on the dam DM and the optical gap layer 150. For example, the optical substrate OS1 can overlap or extend across an interface between the dam DM and the optical gap layer 150.

A lower edge of the second substrate 201 can come into contact with an upper surface of the dam DM. The dam DM can support the lower edge of the second substrate 201. Also, an outer edge surface of the second substrate 201 can be flush with an outer edge surface of the dam DM, but examples are not limited thereto.

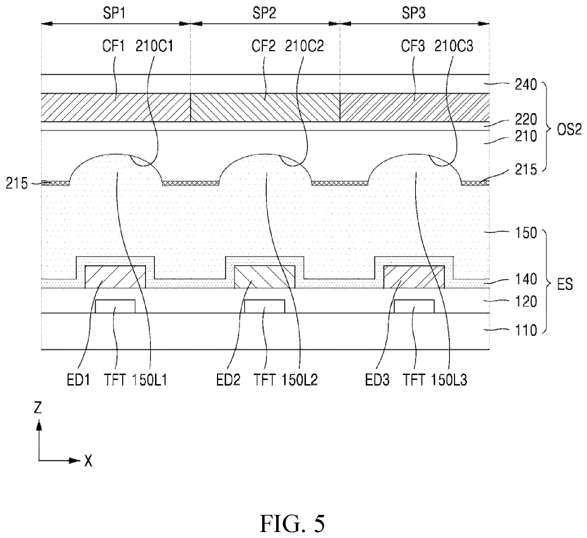

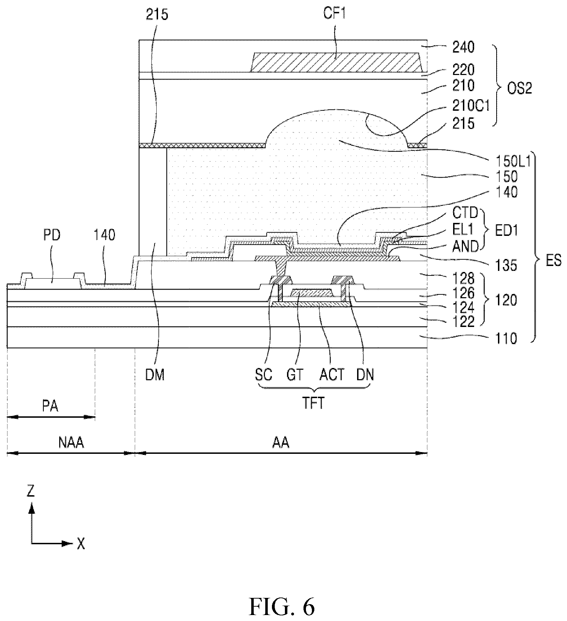

FIG. 5 is a schematic cross-sectional view showing one pixel of the display device according to one example of the present disclosure and shows an area corresponding to FIG. 3. FIG. 6 is a schematic cross-sectional view showing one pixel of the display device according to one example of the present disclosure and shows an area corresponding to FIG. 4. The example shown in FIGS. 5 and 6 is the same as the example shown in FIGS. 3 and 4, except that it includes a light-blocking layer 215 instead of the black matrix 230. Also, the light-blocking layer 215 can be disposed between the lower surface of the second substrate 201 and an upper surface of the optical gap layer 150 and between the adjacent subpixels (e.g., at a location closer to the light emitting elements).

Referring to FIGS. 5 and 6, the display device according to one example of the present disclosure can include the light-emitting array substrate ES and an optical substrate OS2. The light-emitting array substrate ES and the optical substrate OS2 can be manufactured separately and then bonded together.

The light-emitting array substrate ES can include the first substrate 110, the plurality of thin film transistors TFT disposed on the first substrate 110, the insulating layer 120 covering the plurality of thin film transistors TFT, the first, second and third light-emitting elements ED1, ED2, and ED3 disposed on the insulating layer 120, the passivation layer 140 covering the first, second and third light-emitting elements ED1, ED2, and ED3 and disposed on the insulating layer 120, the optical gap layer 150 disposed on the passivation layer 140, and the first, second and third lenses 150L1, 150L2, and 150L3 formed on the upper portion of the optical gap layer 150.

The optical substrate OS2 can include the second substrate 210, the color buffer layer 220 disposed on the second substrate 210, the first, second and third color filters CF1, CF2, and CF3 disposed on the color buffer layer 220, and the protective layer 240 covering the first, second and third color filters CF1, CF2, and CF3, and the light-blocking layer 215 disposed on the lower surface of the second substrate 210.

For example, in the first sub-pixel SP1, the first light-emitting element ED1, the first lens 150L1, and the first color filter CF1 can be disposed to overlap with each other. In the second sub-pixel SP2, the second light-emitting element ED2, the second lens 150L2, and the second color filter CF2 can be disposed to overlap each other. In the third sub-pixel SP3, the third light-emitting element ED3, the second lens 150L3, and the third color filter CF3 can be disposed to overlap with each other.

The lower surface of the second substrate 210 can be provided with the first, second and third concave portions 210C1, 210C2, and 210C3. The light-blocking layer 215 can include openings exposing the first, second and third concave portions 210C1, 210C2, and 210C3. The light-blocking layer 215 can be disposed on the lower surface of the second substrate 210 excluding the first, second and third concave portions 210C1, 210C2, and 210C3.

The upper surface of the optical gap layer 150 can come into contact with the light-blocking layer 215 (e.g., an upper surface of the optical gap layer 150 can directly contact a lower surface of the light-blocking layer 215 of the optical substrate OS2). The first, second and third lenses 150L1, 150L2, and 150L3 can be accommodated in the first, second and third concave portions 210C1, 210C2, and 210C3 of the second substrate 210 through the openings of the light-blocking layer 215.

The upper surface of the dam DM can come into contact with the light-blocking layer 215 disposed on the lower surface of the second substrate 210. The dam DM can support the lower edge of the second substrate 210 through the light-blocking layer 215.

In one example, the light-blocking layer 215 can protrude horizontally below the first, second and third concave portions 210C1, 210C2, and 210C3 to overlap with edges of the first, second and third concave portions 210C1, 210C2, and 210C3. Widths of the openings of the light-blocking layer 215 can be smaller than widths of the first, second and third concave portions 210C1, 210C2, and 210C3 of the second substrate 210. The light-blocking layer 215 can be inserted into lower portions of the first, second and third lenses 150L1, 150L2, and 150L3.

The light-blocking layer 215 can include a metal material capable of absorbing light. The light-blocking layer 215 can be formed of, for example, one of molybdenum (Mo), chromium (Cr), titanium (Ti), niobium (Nb), manganese (Mn), and tantalum (Ta), or an alloy thereof. However, the examples are not limited thereto, and the light-blocking layer 215 can be made of another metal capable of absorbing light.

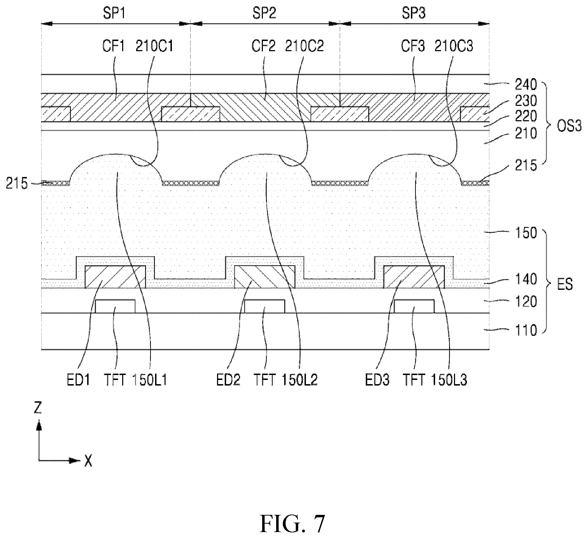

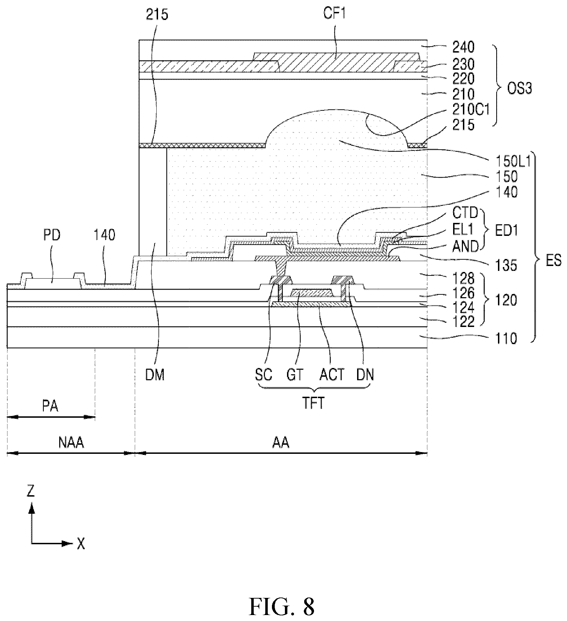

FIG. 7 is a schematic cross-sectional view showing one pixel of the display device according to one example of the present disclosure and shows an area corresponding to FIG. 3. FIG. 8 is a schematic cross-sectional view showing one pixel of the display device according to one example t of the present disclosure and shows an area corresponding to FIG. 4. The examples shown in FIGS. 7 and 8 are the same as the examples illustrated in FIGS. 3 and 4, except that they further include the light-blocking layer 215 in addition to the black matrix 230 (e.g., includes both a light-blocking layer and a black matrix). Also, the black matrix 230 can overlap with or be disposed over corresponding portions of the light-blocking layer 215 in the areas between adjacent subpixels. According to an example, a portion of the black matrix 230 can be wider than a corresponding portion of the light-blocking layer 215, but examples are not limited thereto.

Referring to FIGS. 7 and 8, the display device according to one example of the present disclosure can include the light-emitting array substrate ES and an optical substrate OS3. The light-emitting array substrate ES and the optical substrate OS3 can be manufactured separately and bonded.

The light-emitting array substrate ES can include the first substrate 110, the plurality of thin film transistors TFT disposed on the first substrate 110, the insulating layer 120 covering the plurality of thin film transistors TFT, the first, second and third light-emitting elements ED1, ED2, and ED3 disposed on the insulating layer 120, the passivation layer 140 covering the first, second and third light-emitting elements ED1, ED2, and ED3 and disposed on the insulating layer 120, the optical gap layer 150 disposed on the passivation layer 140, and the first, second and third lenses 150L1, 150L2, and 150L3 formed on the upper portion of the optical gap layer 150.

For example, in the first sub-pixel SP1, the first lens 150L1 can be positioned to overlap with the first light-emitting element ED1, in the second sub-pixel SP2, the second lens 150L2 can be positioned to overlap with the second light-emitting element ED2, and in the third sub-pixel SP3, the third lens 150L3 can be positioned to overlap with the third light-emitting element ED3.

The optical substrate OS3 can include the second substrate 210, the color buffer layer 220 disposed on the second substrate 210, the black matrix 230 disposed on the color buffer layer 220, the first, second and third color filters CF1, CF2, and CF3 disposed on the openings of the black matrix 230, the protective layer 240 covering the first, second and third color filters CF1, CF2, and CF3, and the light-blocking layer 215 disposed on the lower surface of the second substrate 210.

The lower surface of the second substrate 210 can be provided with the first, second and third concave portions 210C1, 210C2, and 210C3. The light-blocking layer 215 can include openings exposing the first, second and third concave portions 210C1, 210C2, and 210C3. The light-blocking layer 215 can be disposed on the lower surface of the second substrate 210 excluding the first, second and third concave portions 210C1, 210C2, and 210C3. According to an example, the light-blocking layer 215 can surround the first, second and third concave portions 210C1, 210C2, and 210C3 in a plan view.

The upper surface of the optical gap layer 150 can come into contact with the light-blocking layer 215. The first, second and third lenses 150L1, 150L2, and 150L3 can be accommodated in the first, second and third concave portions 210C1, 210C2, and 210C3 of the second substrate 210 through the openings of the light-blocking layer 215.

For example, the first, second and third concave portions 210C1, 210C2, and 210C3 of the second substrate 210 can correspond to the first, second and third lenses 150L1, 150L2, and 150L3. For example, in the first sub-pixel SP1, the first concave portion 210C1 can be positioned to overlap with the first light-emitting element ED1, in the second sub-pixel SP2, the second concave portion 210C2 can be positioned to overlap with the second light-emitting element ED2, and in the third sub-pixel SP3, the third concave portion 210C3 can be positioned to overlap with the third light-emitting element ED3.

Referring to FIG.8, the upper surface of the dam DM can come into contact with the light-blocking layer 215 disposed on the lower surface of the second substrate 210. The dam DM can support the lower edge of the second substrate 210 through the light-blocking layer 215.

In one example, the light-blocking layer 215 can protrude in the X-axis direction to overlap with the edges of the first, second and third concave portions 210C1, 210C2, and 210C3, but is not limited thereto. The widths of the openings of the light-blocking layer 215 can be smaller than the widths of the first, second and third concave portions 210C1, 210C2, and 210C3 of the second substrate 210. The light-blocking layer 215 can be inserted into the lower portions of the first, second and third lenses 150L1, 150L2, and 150L3.

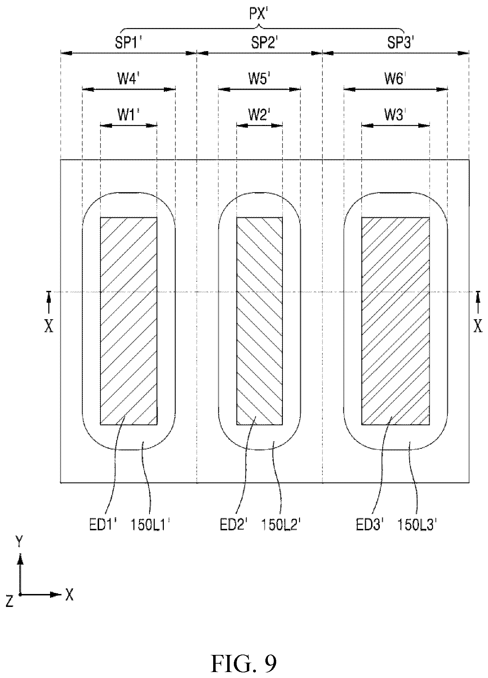

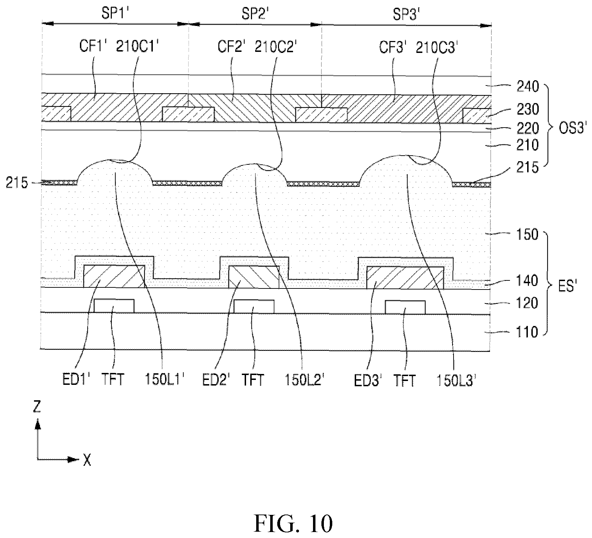

FIG. 9 is a schematic plan view showing one pixel of the display device according to one example of the present disclosure. FIG. 10 is a cross-sectional view of the display device along line X-X in FIG. 9 and shows an area corresponding to FIG. 3. The shown in FIGS. 9 and 10 are the same as the examples shown in FIGS. 7 and 8, except that the widths of the first, second and third light-emitting elements are different and the widths of the first, second and third lenses are different.

A pixel PX' of the display device according to one example of the present disclosure can include a plurality of sub-pixels. Referring to FIGS. 9 and 10, a pixel PX' of the display device according to one example of the present disclosure can include a first sub-pixel SP1', a second sub-pixel SP2', and a third sub-pixel SP3', but is not limited thereto. More or less sub-pixels can be included. As one example, a pixel PX' of the display device according to one example of the present disclosure can include four sub-pixels. For example, each of the first sub-pixel SP1', the second sub-pixel SP2', and the third sub-pixel SP3' can be, for example, any one of a red sub-pixel, a green sub-pixel, and a blue sub-pixel.

The first sub-pixel SP1' can be, for example, a red sub-pixel, the second sub-pixel SP2' can be, for example, a green sub-pixel, and the third sub-pixel SP3' can be, for example, a blue sub-pixel, but is not limited thereto.

The first sub-pixel SP1' can include a first light-emitting element ED1', and a first lens 150L1' overlapping with the first light-emitting element ED1'. The second sub-pixel SP2' can include a second light-emitting element ED2', and a second lens 150L2' overlapping with the second light-emitting element ED2'. The third sub-pixel SP3' can include a third light-emitting element ED3', and a third lens 150L3' overlapping with the third light-emitting element ED3'. For example, the first light-emitting element ED1' can be a red light-emitting element, the second light-emitting element ED2' can be a green light-emitting element, and the third light-emitting element ED3' can be a blue light-emitting element, but is not limited thereto.

For example, a width of each of the plurality light-emitting elements can be different from each other, and a width of each of the plurality lenses can be different from each other.

A width W1' of the first light-emitting element ED1', a width W2' of the second light-emitting element ED2', and a width W3' of the third light-emitting element ED3' can be different, and a width W4' of the first lens 150L1', a width W5' of the second lens 150L2', and the width W6' of the third lens 150L3' can be different. The width W3' of the third light-emitting element ED3' can be larger than the width W1' of the first light-emitting element ED1', and the width W2' of the second light-emitting element ED2' can be smaller than the width W1' of the first light-emitting element ED1'. The width W6' of the third lens 150L3' can be larger than the width W4' of the first lens 150L1', and the width W5' of the second lens 150L2' can be smaller than the width W4' of the first lens 150L1'.

The display device according to one example of the present disclosure can include the light-emitting array substrate ES' and an optical substrate OS3'. The light-emitting array substrate ES' and the optical substrate OS3' can be manufactured separately and then bonded together.

The light-emitting array substrate ES' can include the first substrate 110, the plurality of thin film transistors TFT disposed on the first substrate 110, the insulating layer 120 covering the plurality of thin film transistors TFT, the first, second and third light-emitting elements ED1', ED2', and ED3' disposed on the insulating layer 120, the passivation layer 140 covering the first, second and third light-emitting elements ED1', ED2', and ED3' and disposed on the insulating layer 120, the optical gap layer 150 disposed on the passivation layer 140, and the first, second and third lenses 150L1', 150L2', and 150L3' formed on the upper portion of the optical gap layer 150.

The width W4' of the first lens 150L1', the width W5' of the second lens 150L2', and the width W6' of the third lens 150L3' can be different, and a height of the first lens 150L1', a height of the second lens 150L2', and a height of the third lens 150L3' can be different. The height of the third lens 150L3' can be larger than the height of the first lens 150L1', and the height of the second lens 150L2' can be smaller than the height of the first lens 150L1'.

The optical substrate OS3' can include the second substrate 210, the color buffer layer 220 disposed on the second substrate 210, the black matrix 230 disposed on the color buffer layer 220, the first, second and third color filters CF1', CF2', and CF3' disposed on the openings of the black matrix 230, the protective layer 240 covering the first, second and third color filters CF1', CF2', and CF3', and the light-blocking layer 215 disposed on the lower surface of the second substrate 210. In one example, one of a black matrix 230 and the light-blocking layer 215 can be omitted.

The lower surface of the second substrate 210 can be provided with first, second and third concave portions 210C1', 210C2', and 210C3'. The first, second and third concave portions 210C1', 210C2', and 210C3' can correspond to the first, second and third lenses 150L1', 150L2', and 150L3'. Widths and depths of the first, second and third concave portions 210C1', 210C2', and 210C3' can be different, and the widths and heights of the first, second and third lenses 150L1', 150L2', and 150L3' can be also different.

The width and depth of the third concave portion 210C3' can be larger than the width and depth of the first concave portion 210C1', and the width and depth of the second concave portion 210C2' can be smaller than the width and depth of the first concave portion 210C1'. For example, the width and depth of the third lens 150L3' can be larger than the width and depth of the first lens 150L1', and the width and depth of the second lens 150L2' can be smaller than the width and depth of the first lens 150L1'.

The light-blocking layer 215 can include openings exposing the first, second and third concave portions 210C1', 210C2', and 210C3'. The light-blocking layer 215 can be disposed on the lower surface of the second substrate 210 excluding the first, second and third concave portions 210C1', 210C2', and 210C3'. For example, the light-blocking layer 215 can surround the first, second and third concave portions 210C1', 210C2', and 210C3' in a plan view.

The upper surface of the optical gap layer 150 can come into contact with the light-blocking layer 215. The first, second and third lenses 150L1', 150L2', and 150L3' can be accommodated in the first, second and third concave portions 210C1', 210C2', and 210C3' of the second substrate 210 through the openings of the light-blocking layer 215.

Widths of the first, second and third concave portions 210C1', 210C2', and 210C3' can be different , and the widths of the first, second and third lenses 150L1', 150L2', and 150L3' can be also different. The width of the third color filter CF3' can be larger than the width of the first color filter CF1', and the width of the second color filter CF2' can be smaller than the width of the first color filter CF1'. For example, the width of the third lens 150L3' can be larger than the width of the first lens 150L1', and the width of the second lens 150L2' can be smaller than the width of the first lens 150L1'.

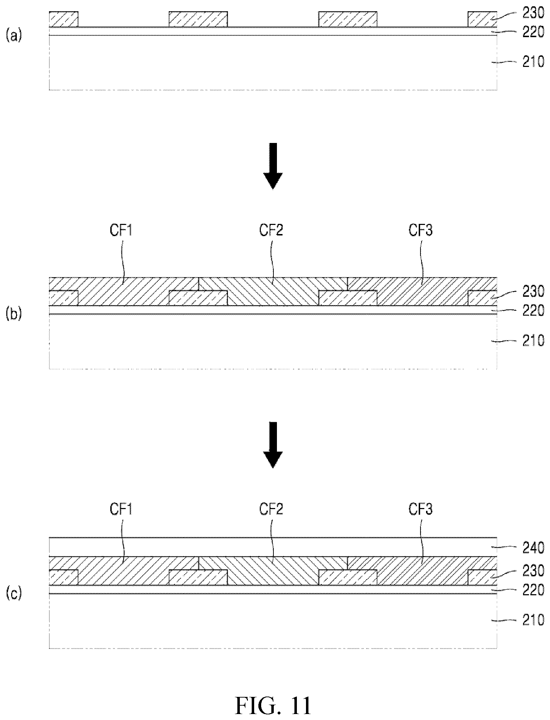

FIGS. 11 to 13 show a process of manufacturing a display device according to the example shown in FIG. 3.

Referring to FIG. 11, after the color buffer layer 220 is formed on the second substrate 210, the black matrix 230 having openings is formed (step a), but is not limited thereto. In one example, the color buffer layer 220 can be omitted. For example, the black matrix 230 having openings is formed on the second substrate 210. Next, the first, second and third color filters CF1, CF2, and CF3 are formed in the openings of the black matrix 230 (step b). Next, the protective layer 240 covering the first, second and third color filters CF1, CF2, and CF3 is formed (step c).

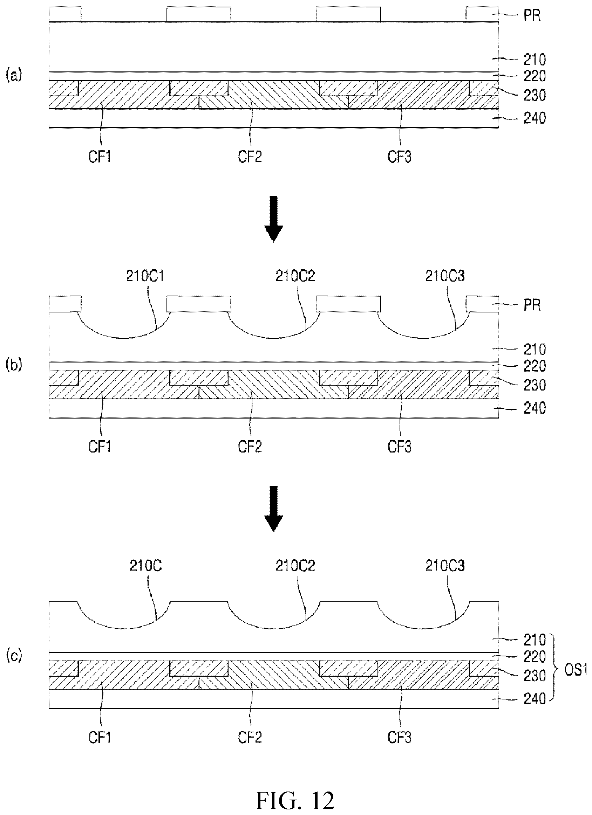

Referring to FIG. 12, the second substrate 210 on which the black matrix BM, the first, second and third color filters CF1, CF2, and CF3, and the protective layer 240 are formed is flipped (e.g., turned upside down), and then a photoresist pattern PR having openings corresponding to positions at which the first, second and third concave portions are formed is formed on the lower surface of the second substrate 210 (step a). Here, the widths of the openings can be the same. Next, the first, second and third concave portions 210C1, 210C2, and 210C3 are formed on the second substrate 210 using a wet etching process (step b). Next, a photoresist pattern PR is removed to manufacture the optical substrate OS1 (step c).

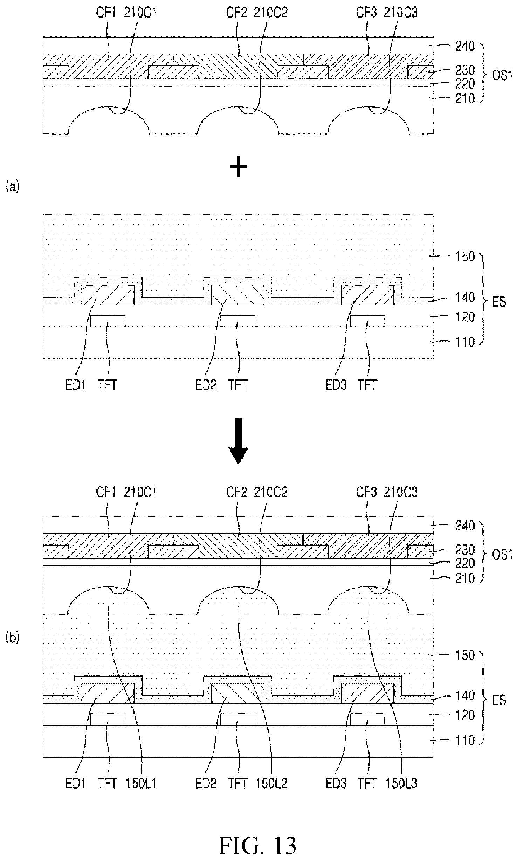

Referring to FIG. 13, the optical substrate OS1 is positioned on a separately manufactured light-emitting array substrate ES so that the lower surface of the second substrate 210 faces the light-emitting array substrate ES (step a).

The light-emitting array substrate ES can include the first substrate 110, the plurality of thin film transistors TFT disposed on the first substrate 110, the insulating layer 120 covering the plurality of thin film transistors TFT, the first, second and third light-emitting elements ED1, ED2, and ED3 disposed on the insulating layer 120, the passivation layer 140 covering the first, second and third light-emitting elements ED1, ED2, and ED3 and disposed on the insulating layer 120, the optical gap layer 150 disposed on the passivation layer 140, and the dam DM (see FIG. 4) surrounding side surfaces of the optical gap layer 150. After the dam DM is first formed in a closed curve shape on the first substrate 110, the space defined by the dam DM can be coated with the optical gap layer 150. The dam DM can maintain the closed curve shape as a preliminarily cured or cured state, and the optical gap layer 150 can in a fluid state because it is not yet cured. Accordingly, the optical gap layer 150 can have a flat upper surface. For example, the optical gap layer 150 can still be in a malleable state with a flat upper surface before it is pressed into the concave portions of the optical substrate OS1. In this way, the lenses can exactly match and perfectly fit into the concave portions of the optical substrate OS1.

Next, the light-emitting array substrate ES and the optical substrate OS1 are bonded in a vacuum state. Since a part of the optical gap layer 150 fills the first, second and third concave portions 210C1, 210C2, and 210C3 of the second substrate 210, the first, second and third lenses 150L1, 150L2, and 150L3 can be formed. The optical gap layer 150 can be cured in a state in which the light-emitting array substrate ES and the optical substrate OS1 are bonded.

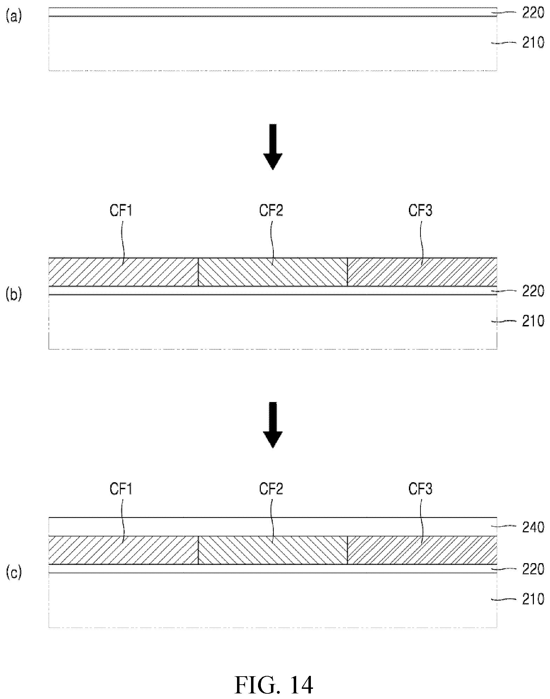

FIGS. 14 to 16 show a process of manufacturing a display device according to the example shown in FIG. 5.

Referring to FIG. 14, the color buffer layer 220 is formed on the second substrate 210 (step a). For example, the color buffer layer 220 can be configured to cover the second substrate 210. In one example, the color buffer layer 220 can be omitted. Next, the first, second and third color filters CF1, CF2, and CF3 are formed in the color buffer layer 220 (step b). Alternatively, when the color buffer layer 220 is omitted, the first, second and third color filters CF1, CF2, and CF3 can be formed in the second substrate 210. Next, the protective layer 240 covering the first, second and third color filters CF1, CF2, and CF3 is formed (step c).

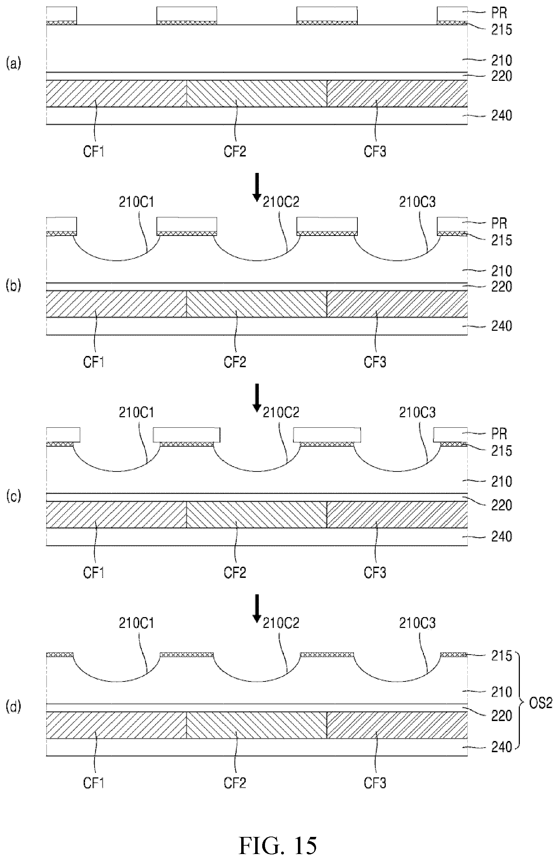

Referring to FIG. 15, the second substrate 210 on which the first, second and third color filters CF1, CF2, and CF3 and the protective layer 240 are formed is flipped (e.g., turned upside down), and then the light-blocking layer 215 and the photoresist pattern PR that have the openings corresponding to positions at which the first, second and third concave portions are formed are formed on the lower surface of the second substrate 210 (step a). Here, the widths of the openings can be the same. Next, the first, second and third concave portions 210C1, 210C2, and 210C3 are formed on the second substrate 210 using a wet etching process (step b). For example, the first, second and third concave portions 210C1, 210C2, and 210C3 can be formed on the second substrate 210 using the light-blocking layer 215 and the photoresist pattern PR by a wet etching process. Next, a part of the light-blocking layer 215 protruding above the first, second and third concave portions 210C1, 210C2, and 210C3 is removed using a wet etching process (step c). In one example, the step c can be omitted. Next, the photoresist pattern PR is removed to manufacture the optical substrate OS2 with the concave portions (step d).

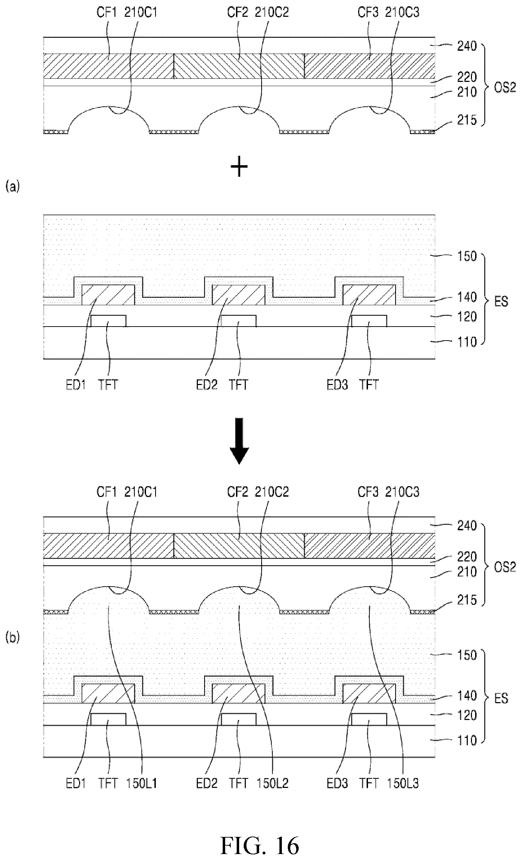

Referring to FIG. 16, the optical substrate OS2 is positioned on a separately manufactured light-emitting array substrate ES so that the lower surface of the second substrate 210 faces the light-emitting array substrate ES (step a). Next, the light-emitting array substrate ES and the optical substrate OS2 are vacuum-bonded. Since a part of the optical gap layer 150 fills the first, second and third concave portions 210C1, 210C2, and 210C3 of the second substrate 210, the first, second and third lenses 150L1, 150L2, and 150L3 can be formed. For example, the optical gap layer 150 can be pressed into the first, second and third concave portions 210C1, 210C2, and 210C3 of the second substrate 210 to form lenses that exactly match and fit into the first, second and third concave portions 210C1, 210C2, and 210C3.

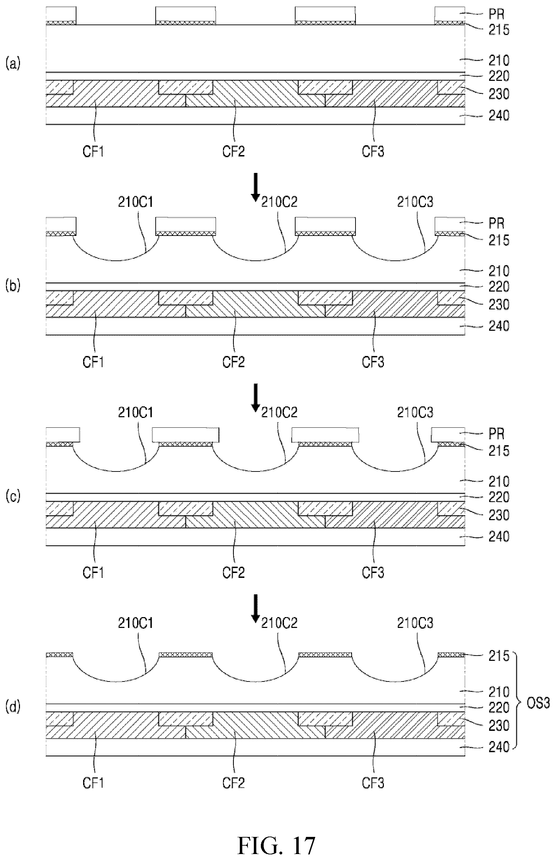

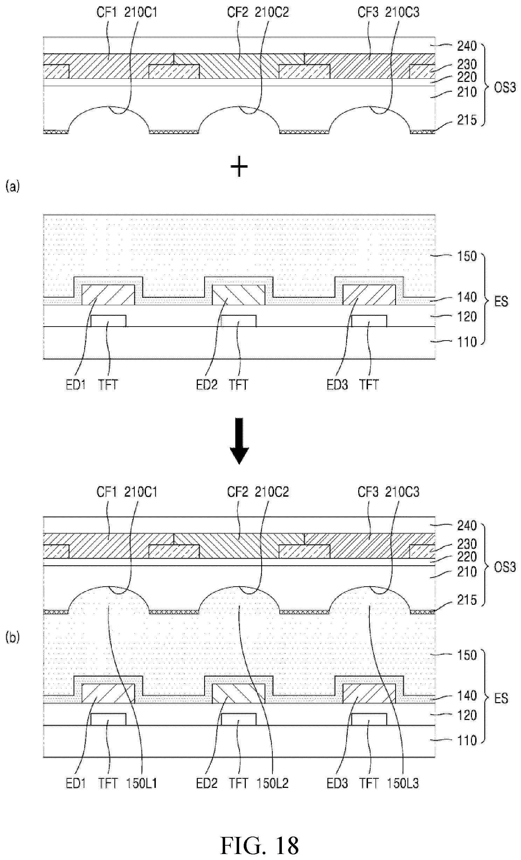

FIGS. 17 and 18 show a process of manufacturing a display device according to the example shown in FIG. 7.

Referring to FIG. 17, the second substrate 210 on which the black matrix BM, the first, second and to third color filters CF1, CF2, and CF3, and the protective layer 240 are formed is flipped, and then the light-blocking layer 215 and the photoresist pattern PR that have the openings corresponding to positions at which the first, second and third concave portions are formed are formed on the lower surface of the second substrate 210 (step a). Here, the widths of the openings can be the same. Next, the first, second and third concave portions 210C1, 210C2, and 210C3 are formed on the second substrate 210 using a wet etching process (step b). Next, a part of the light-blocking layer 215 protruding above the first, second and third concave portions 210C1, 210C2, and 210C3 is removed using a wet etching process (step c). In one example, the step c can be omitted. Next, the photoresist pattern PR is removed and the light-blocking layer 215 is exposed to manufacture the optical substrate OS3 (step d).

Referring to FIG. 18, the optical substrate OS3 is positioned on a separately manufactured light-emitting array substrate ES so that the lower surface of the second substrate 210 faces the light-emitting array substrate ES (step a). Next, the light-emitting array substrate ES and the optical substrate OS3 are vacuum-bonded. Since a part of the optical gap layer 150 fills the first, second and third concave portions 210C1, 210C2, and 210C3 of the second substrate 210, the first, second and third lenses 150L1, 150L2, and 150L3 can be formed.

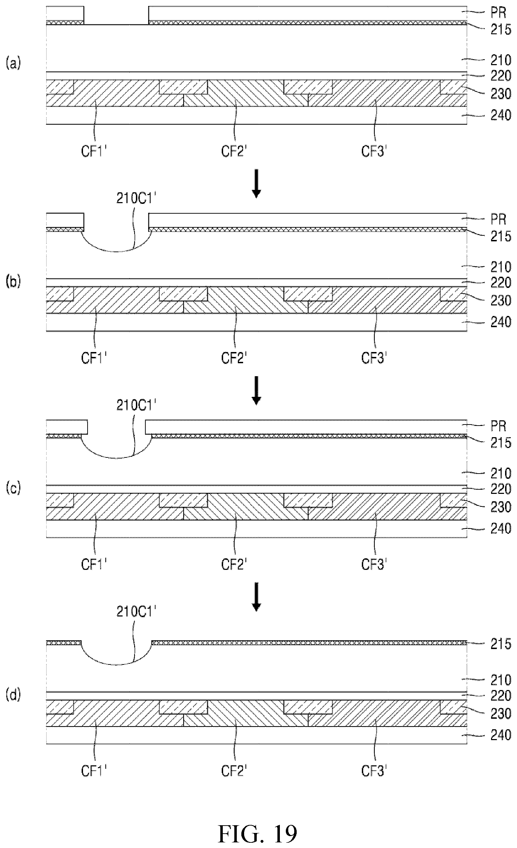

FIGS. 19 to 21 show a process of manufacturing a display device according to the example shown in FIG. 10.

As one example, an optical substrate including first, second and third color filters disposed on a second substrate, and first, second and third concave portions provided to overlap with the first, second and third color filters on a lower surface of the second substrate can be formed, but is not limited thereto.

Referring to FIG. 19, the second substrate 210 on which the black matrix BM, the first, second and third color filters CF1', CF2', and CF3', and the protective layer 240 are formed is flipped, and then the light-blocking layer 215 and the photoresist pattern PR that have the opening corresponding to the position at which the first concave portion is formed are formed on the lower surface of the second substrate 210 (step a). Next, the first concave portion 210C1' is formed on the second substrate 210 using the wet etching process (step b). Next, a part of the light-blocking layer 215 protruding above the first concave portion 210C1' is removed using the wet etching process (step c). In one example, the step c can be omitted. Next, the photoresist pattern PR is removed (step d).

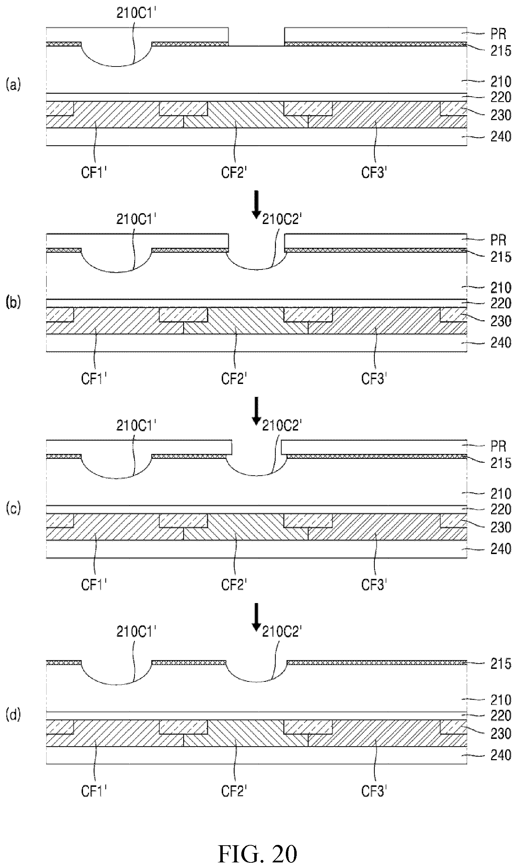

Referring to FIG. 20, the light-blocking layer 215 and the photoresist pattern PR that have the opening corresponding to the position at which the second concave portion is formed are formed on the lower surface of the second substrate 210 on which the first concave portion 210C1' is formed (step a). Next, the second concave portion 210C2' is formed on the second substrate 210 using the wet etching process (step b). Next, a part of the light-blocking layer 215 protruding above the second concave portion 210C2' is removed using the wet etching process (step c). In one example, the step c can be omitted. Next, the photoresist pattern PR is removed (step d).

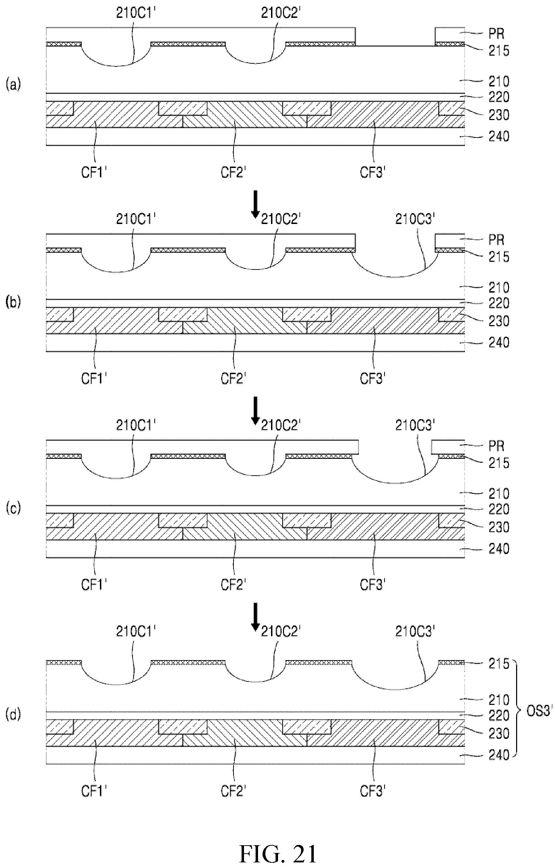

Referring to FIG. 21, the light-blocking layer 215 and the photoresist pattern PR that have the opening corresponding to the position at which the third concave portion is formed are formed on the lower surface of the second substrate 210 on which the first concave portion 210C1' and the second concave portion 210C2' are formed (step a). Next, the third concave portion 210C3' is formed on the second substrate 210 using the wet etching process (step b). Next, a part of the light-blocking layer 215 protruding above the third concave portion 210C3' is removed using the wet etching process (step c). In one example, the step c can be omitted. Next, the photoresist pattern PR is removed to manufacture the optical substrate OS3' (step d).

As one example, the light-emitting array substrate and the optical substrate can be bonded so that the first, second and third concave portions are filled by a part of the optical gap layer, but is not limited thereto.

The optical substrate OS3' is positioned on a separately manufactured light-emitting array substrate ES so that the lower surface of the second substrate 210 faces the light-emitting array substrate ES. Next, the light-emitting array substrate ES and the optical substrate OS3' are vacuum-bonded. Since a part of the optical gap layer 150 fills the first, second and third concave portions 210C1', 210C2', and 210C3' of the second substrate 210, the first, second and third lenses 150L1', 150L2', and 150L3' can be formed. For example, the first, second and third lenses 150L1', 150L2', and 150L3' can be formed to correspond to the first, second and third concave portions 210C1', 210C2', and 210C3' of the second substrate 210.

A display device according to various examples of the present disclosure can be described as follows.

According to examples of the present disclosure, there is provided a display device including first, second and third light-emitting elements disposed on a first substrate, an optical gap layer disposed on the first, second and third light-emitting elements, a second substrate disposed on the optical gap layer, and first, second and third color filters disposed on the second substrate, in which first, second and third concave portions are provided on a lower surface of the second substrate, and first, second and third lenses that fill the first, second and third concave portions, respectively, are provided on an upper surface of the optical gap layer.

According to some examples of the present disclosure, refractive indexes of the first, second and third lenses can be higher than a refractive index of the second substrate.

According to some examples of the present disclosure, the second substrate can be formed of glass, and the first, second and third lenses can be formed of an organic insulation material having a refractive index higher than the refractive index of the glass.

According to some examples of the present disclosure, a black matrix having openings in which the first, second and third color filters are disposed can be further disposed on the second substrate.

According to some examples of the present disclosure, a light-blocking layer having openings exposing the first, second and third concave portions can be further disposed on a lower surface of the second substrate.

According to some examples of the present disclosure, a black matrix having openings in which the first, second and third color filters are disposed can be further disposed on the second substrate, and a light-blocking layer having openings exposing the first, second and third concave portions can be further disposed on the lower surface of the second substrate.

According to some examples of the present disclosure, the light-blocking layer can include a metal material that absorbs light.

According to some examples of the present disclosure, the light-blocking layer can be inserted into lower portions of the first, second and third lenses.

According to some examples of the present disclosure, the display device can further include a dam surrounding side surfaces of the optical gap layer, in which the first, second and third lenses can protrude more than an upper surface of the dam.

According to some examples of the present disclosure, a thickness of the optical gap layer can be in a range of 25 µm to 35 µm (e.g., 30 µm).

According to some examples of the present disclosure, the first color filter can be positioned to overlap with the first concave portion, the second color filter can be positioned to overlap with the second concave portion, and the third color filter can be positioned to overlap with the third concave portion.

According to some examples of the present disclosure, a width of the third lens can be larger than a width of the first lens, and a width of the second lens can be smaller than a width of the first lens.

According to some examples of the present disclosure, widths and depths of the first, second and third concave portions can be different.

According to examples of the present disclosure, there is provided a display device including a light-emitting array substrate including first, second and third light-emitting elements disposed on a first substrate, an optical gap layer disposed on the first, second and third light-emitting elements, first, second and third lenses formed on an upper surface of the optical gap layer, and a dam surrounding side surfaces of the optical gap layer, and an optical substrate including a second substrate, first, second and third color filters disposed on the second substrate, and first, second and third concave portions provided to overlap with the first, second and third color filters on a lower surface of the second substrate, in which the light-emitting array substrate and the optical substrate are bonded by the optical gap layer so that the first, second and third lenses fill the first, second and third concave portions, respectively.

According to some examples of the present disclosure, a width of the third light-emitting element can be larger than a width of the first light-emitting element, and a width of the second light-emitting element can be smaller than a width of the first light-emitting element.

According to some examples of the present disclosure, the second substrate can be formed of glass, and the first, second and third lenses can be formed of an organic insulation material having a refractive index higher than the refractive index of the glass.

According to some examples of the present disclosure, a black matrix having openings in which the first, second and third color filters are disposed can be further disposed on the second substrate.

According to some examples of the present disclosure, a light-blocking layer having openings exposing the first, second and third concave portions can be further disposed on a lower surface of the second substrate.

According to some examples of the present disclosure, a black matrix having openings in which the first, second and third color filters are disposed can be further disposed on the second substrate, and a light-blocking layer having openings exposing the first, second and third concave portions can be further disposed on the lower surface of the second substrate.

According to some examples of the present disclosure, the light-blocking layer can include a metal material that absorbs light.

According to some examples of the present disclosure, the first, second and third lenses can protrude more than an upper surface of the dam.

According to examples of the present disclosure, there is provided a method of manufacturing a display device including forming a light-emitting array substrate including first, second and third light-emitting elements disposed on a first substrate, an optical gap layer disposed on the first, second and third light-emitting elements, and a dam surrounding side surfaces of the optical gap layer, forming an optical substrate including first, second and third color filters disposed on a second substrate, and first, second and third concave portions provided to overlap with the first, second and third color filters on a lower surface of the second substrate, and bonding the light-emitting array substrate and the optical substrate so that the first, second and third concave portions are filled by a part of the optical gap layer.

According to some examples of the present disclosure, the bonding of the light-emitting array substrate and the optical substrate can be performed in a vacuum.

According to some examples of the present disclosure, the method can further include curing the optical gap layer after the bonding of the light-emitting array substrate and the optical substrate.

According to some examples of the present disclosure, the method can further include forming a light-blocking layer that has the openings corresponding to positions at which the first, second and third concave portions are formed on a lower surface of the second substrate, and removing a part of the light-blocking layer protruding above the first, second and third concave portions using an etching process.

According to examples of the present disclosure, there is provided a display device including a plurality of sub-pixels, each including a light emitting element disposed on a first substrate; an optical gap layer disposed on the light emitting element; a second substrate disposed on the optical gap layer, a plurality of concave portions are provided on a lower surface of the second substrate, and a plurality of lenses that fill the plurality of concave portions, respectively, are provided on an upper surface of the optical gap layer.

According to some examples of the present disclosure, refractive indexes of the plurality of lenses can be higher than a refractive index of the second substrate.

According to an example, a display device and its manufacturing method can provide several distinct advantages. For example, by fabricating the light-emitting array substrate and the optical substrate as separate components, the high-risk process of lens formation can be decoupled from the high-value light-emitting elements. This separation can help ensure that any defects occurring during the creation of the concave lens molds on the optical substrate do not necessitate the disposal of the costly light-emitting array, thereby significantly improving overall production yield and reducing manufacturing costs.

Further, by utilizing these pre-formed concave portions as a mold can simplify the manufacturing process and allow for the consistent and reproducible formation of lenses with a specific desired shape. Thus, the final assembled device can successfully internalize the functions of lenses and color filters, eliminating the need for extra layers or separate viewing angle control films and polarizing plates, which can result in a thinner device profile and enhanced reliability.

Further examples are set out in the clauses below:
1. A display device comprising:
   first, second and third light-emitting elements disposed on a first substrate;
   an optical gap layer disposed on the first, second and third light-emitting elements;
   a second substrate disposed on the optical gap layer;
   first, second and third color filters disposed on the second substrate;
   first, second and third concave portions on a lower surface of the second substrate; and
   first, second and third lenses on an upper surface of the optical gap layer,
   wherein the first, second and third lenses fill the first, second and third concave portions, respectively.
2. The display device of clause 1, wherein refractive indexes of the first, second and third lenses are higher than a refractive index of the second substrate.
3. The display device of clause 1 or 2, wherein the second substrate includes glass, and
   wherein the first, second and third lenses include an organic insulation material having a refractive index higher than a refractive index of the glass.
4. The display device of any one of the preceding clauses, further comprising a black matrix disposed on the second substrate,
   wherein portions of the first, second and third color filters are disposed in openings in the black matrix.
5. The display device of any one of the preceding clauses, further comprising a light-blocking layer disposed on a lower surface of the second substrate,
   wherein the light-blocking layer includes openings exposing the first, second and third concave portions.
6. The display device of clause 5, wherein the light-blocking layer includes a metal material configured to absorb light.
7. The display device of clause 5, wherein the light-blocking layer is inserted into lower portions of the first, second and third lenses.
8. The display device of any one of the preceding clauses, further comprising a dam surrounding side surfaces of the optical gap layer,
   wherein the first, second and third lenses protrude higher than an upper surface of the dam.
9. The display device of any one of the preceding clauses, wherein a thickness of the optical gap layer is 25 µm to 35 µm.
10. The display device of any one of the preceding clauses, wherein the first color filter overlaps with the first concave portion,
   wherein the second color filter overlaps with the second concave portion, and
   wherein the third color filter overlaps with the third concave portion.
11. The display device of any one of the preceding clauses, wherein a width of the third lens is larger than a width of the first lens, and
   wherein a width of the second lens is smaller than a width of the first lens.
12. The display device of any one of the preceding clauses, wherein widths and depths of the first, second and third concave portions are different from each other.
13. A display device comprising:
   a light-emitting array substrate including:
   a first substrate,
   first, second and third light-emitting elements disposed on the first substrate,
   an optical gap layer disposed on the first, second and third light-emitting elements, first, second and third lenses on an upper surface of the optical gap layer, and
   a dam surrounding side surfaces of the optical gap layer; and
   an optical substrate including:
      a second substrate,
      first, second and third color filters disposed on the second substrate, and
      first, second and third concave portions on a lower surface of the second substrate, the first, second and third concave portions overlapping with the first, and third
      color filters, respectively,
      wherein the light-emitting array substrate and the optical substrate are bonded by the optical gap layer and the first, second and third lenses fill the first, second and third concave portions, respectively.
14. The display device of clause 13, wherein a width of the third light-emitting element is larger than a width of the first light-emitting element, and
   wherein a width of the second light-emitting element is smaller than a width of the first light-emitting element.
15. A method of manufacturing a display device, comprising:
   forming a light-emitting array substrate including first, second and third light-emitting elements disposed on a first substrate, an optical gap layer disposed on the first, second and third light-emitting elements, and a dam surrounding side surfaces of the optical gap layer;
   forming an optical substrate including first, second and third color filters disposed on a second substrate, and first, second and third concave portions on a lower surface of the second substrate, the first, second and third concave portions overlapping with the first, second and third color filters; and
   bonding the light-emitting array substrate to the optical substrate and filling the first, second and third concave portions with parts of the optical gap layer.
16. The method of clause 15, wherein the bonding of the light-emitting array substrate and the optical substrate is performed in a vacuum.
17. The method of clause 15 or 16, further comprising curing the optical gap layer after the bonding of the light-emitting array substrate and the optical substrate.
18. The method of any one of clauses 15-17, further comprising:
   forming a light-blocking layer on a lower surface of the second substrate with openings corresponding to positions of the first, second and third concave portions; and
   removing a part of the light-blocking layer protruding above the first, second and third concave portions using an etching process.
19. A display device comprising:
   a plurality of sub-pixels, each including a light emitting element disposed on a first substrate;
   an optical gap layer disposed on the light emitting element;
   a second substrate disposed on the optical gap layer;
   a plurality of concave portions on a lower surface of the second substrate; and
   a plurality of lenses on an upper surface of the optical gap layer, the plurality of lenses filling the plurality of concave portions, respectively.
20. The display device of clause 19, wherein refractive indexes of the plurality of lenses are higher than a refractive index of the second substrate.
21. A display device, comprising:
   first, second and third light-emitting elements disposed on a first substrate;
   an optical gap layer disposed over the first, second and third light-emitting elements, the optical gap layer including first, second and third lenses extending from an upper surface of the optical gap layer; and
   a second substrate disposed on the optical gap layer;
   wherein a lower surface of the second substrate includes first, second and third concave portions, and
   wherein each of the first, second and third lenses has a convex surface corresponding to one of the first, second and third concave portions.

Although the example examples of the present disclosure have been described in more detail with reference to the accompanying drawings, the present disclosure is not necessarily limited to these examples, and various modifications can be carried out without departing from the present disclosure. Accordingly, the examples disclosed in the present disclosure are not intended to limit the present disclosure, but are intended to describe the present disclosure and the scope of the present disclosure is not limited by these examples. Accordingly, it should be understood that the above-described examples are illustrative and not restrictive in all aspects.

## Claims

1. A display device comprising:
first, second and third light-emitting elements disposed on a first substrate;
an optical gap layer disposed on the first, second and third light-emitting elements;
a second substrate disposed on the optical gap layer;
first, second and third color filters disposed on the second substrate;
first, second and third concave portions on a lower surface of the second substrate; and
first, second and third lenses on an upper surface of the optical gap layer,
wherein the first, second and third lenses fill the first, second and third concave portions, respectively.

2. The display device of claim 1, wherein refractive indexes of the first, second and third lenses are higher than a refractive index of the second substrate.

3. The display device of claim 1 or 2, wherein the second substrate includes glass, and
wherein the first, second and third lenses include an organic insulation material having a refractive index higher than a refractive index of the glass.

4. The display device of any one of the preceding claims, further comprising a black matrix disposed on the second substrate,
wherein portions of the first, second and third color filters are disposed in openings in the black matrix.

5. The display device of any one of the preceding claims, further comprising a light-blocking layer disposed on a lower surface of the second substrate,
wherein the light-blocking layer includes openings exposing the first, second and third concave portions.

6. The display device of claim 5, wherein the light-blocking layer includes a metal material configured to absorb light.

7. The display device of claim 5, wherein the light-blocking layer is inserted into lower portions of the first, second and third lenses.

8. The display device of any one of the preceding claims, further comprising a dam surrounding side surfaces of the optical gap layer,
wherein the first, second and third lenses protrude higher than an upper surface of the dam.

9. The display device of any one of the preceding claims, wherein a thickness of the optical gap layer is 25 µm to 35 µm.

10. The display device of any one of the preceding claims, wherein the first color filter overlaps with the first concave portion,
wherein the second color filter overlaps with the second concave portion, and
wherein the third color filter overlaps with the third concave portion.

11. The display device of any one of the preceding claims, wherein a width of the third lens is larger than a width of the first lens, and
wherein a width of the second lens is smaller than a width of the first lens; or optionally
wherein widths and depths of the first, second and third concave portions are different from each other.

12. The display device of claim 1, further comprising:
a light-emitting array substrate that includes:
the first substrate,
the first, second and third light-emitting elements disposed on the first substrate,
the optical gap layer disposed on the first, second and third light-emitting elements,
first, second and third lenses on an upper surface of the optical gap layer, and
a dam surrounding side surfaces of the optical gap layer;
wherein an optical substrate includes:
the second substrate,
the first, second and third color filters disposed on the second substrate, and
the first, second and third concave portions on the lower surface of the second substrate, the first, second and third concave portions overlapping with the first, and third color filters, respectively,
wherein the light-emitting array substrate and the optical substrate are bonded by the optical gap layer and the first.

13. The display device of claim 12, wherein a width of the third light-emitting element is larger than a width of the first light-emitting element, and
wherein a width of the second light-emitting element is smaller than a width of the first light-emitting element.

14. A method of manufacturing a display device, comprising:
forming a light-emitting array substrate including first, second and third light-emitting elements disposed on a first substrate, an optical gap layer disposed on the first, second and third light-emitting elements, and a dam surrounding side surfaces of the optical gap layer;
forming an optical substrate including first, second and third color filters disposed on a second substrate, and first, second and third concave portions on a lower surface of the second substrate, the first, second and third concave portions overlapping with the first, second and third color filters; and
bonding the light-emitting array substrate to the optical substrate and filling the first, second and third concave portions with parts of the optical gap layer.

15. The method of claim 14, wherein the bonding of the light-emitting array substrate and the optical substrate is performed in a vacuum.; or optionally
further comprising curing the optical gap layer after the bonding of the light-emitting array substrate and the optical substrate; or optionally
further comprising:
forming a light-blocking layer on a lower surface of the second substrate with openings corresponding to positions of the first, second and third concave portions; and
removing a part of the light-blocking layer protruding above the first, second and third concave portions using an etching process.
